(19) Europäisches Patentamt
European Patent Office
Office européen des brevets

(11) **EP 2 150 685 B1**

(12) **EUROPÄISCHE PATENTSCHRIFT**

(45) Veröffentlichungstag und Bekanntmachung des Hinweises auf die Patenterteilung:
**14.03.2012 Patentblatt 2012/11**

(21) Anmeldenummer: **08747885.5**

(22) Anmeldetag: **09.05.2008**

(51) Int Cl.:
*B03C 3/51* *(2006.01)*    *B03C 3/74* *(2006.01)*
*C23C 16/38* *(2006.01)*    *F01N 3/01* *(2006.01)*
*F01N 3/027* *(2006.01)*    *F01N 9/00* *(2006.01)*
*F01N 3/022* *(2006.01)*    *B03C 3/12* *(2006.01)*
*B03C 3/017* *(2006.01)*

(86) Internationale Anmeldenummer:
**PCT/AT2008/000163**

(87) Internationale Veröffentlichungsnummer:
**WO 2008/138023 (20.11.2008 Gazette 2008/47)**

(54) **REGELUNG EINES PLASMAREGENERIERTEN RUSSFILTERS**

REGULATION OF A PLASMA-REGENERATED SOOT FILTER

RÉGULATION D'UN FILTRE À SUIE RÉGÉNÉRÉ PAR PLASMA

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **10.05.2007 AT 7322007**

(43) Veröffentlichungstag der Anmeldung:
**10.02.2010 Patentblatt 2010/06**

(73) Patentinhaber: **Fleck, Carl M.**
**2391 Kaltenleutgeben (AT)**

(72) Erfinder: **Fleck, Carl M.**
**2391 Kaltenleutgeben (AT)**

(74) Vertreter: **Henhapel, Bernhard**
**Patentanwälte Kliment & Henhapel**
**Singerstrasse 8**
**A-1010 Wien (AT)**

(56) Entgegenhaltungen:
**EP-A- 0 332 609    WO-A-2006/131406**
**FR-A- 2 861 802    US-A1- 2004 141 890**

## Beschreibung

Die Erfindung betrifft ein Verfahren für den Betrieb einer Filteranordnung zum Abscheiden von Russpartikel aus dem Abgasstrom eines Dieselmotors, gemäß dem Oberbegriff von Anspruch 1.

Bei Vorrichtungen dieser Art werden die im Abgasstrom enthaltenen Russpartikel entfernt, indem das Abgas durch axial verlaufende Kanäle eines aus einem keramischen Werkstoff hergestellten Wabenfilter hindurchgeleitet wird, und an parallel zu den Kanälen verlaufenden Elektroden eine Spannung an den Wabenfilter zur Erzeugung eines normal zu den Kanälen verlaufenden, elektrischen Feldes in den Kanälen angelegt wird. Die Kanäle weisen dabei einen rechteckförmigen Querschnitt, der in Spezialfällen auch quadratisch sein kann, auf, wobei als Kanalhöhe "h" jene Seite definiert wird, die in Feldrichtung orientiert ist, und die Kanalbreite "b" folglich im Wesentlichen normal zur Feldrichtung liegt. Die Kanäle sind in Feldrichtung durch eine Wandstärke "d" des keramischen Werkstoffes voneinander getrennt.

Zur prinzipiellen Ausführung des Wabenkörpers sind mehrere Varianten bekannt. So kennt der Stand der Technik etwa Filtersysteme, bei denen die axial verlaufenden Kanäle beidseitig offen sind ("offene Filter"), oder nur an einer Seite offen, und an der gegenüber liegenden Seite geschlossen ("Wall-flow-Filter" oder "geschlossene Filter"). Bei offenen Filtersystemen werden die Russpartikel mithilfe einer vor dem Wabenkörper angeordneten Entladungselektrode elektrisch aufgeladen, und durch das am Wabenkörper anliegende elektrische Feld abgeschieden. Das elektrische Feld am Wabenkörper kann dabei so betrieben werden, dass innerhalb der Kanäle ein Plasma erzeugt wird, mit dem abgeschiedene Russpartikel in gasförmige Substanzen umgewandelt werden (so genannte "plasmaregenerierte Filtersysteme"). Elektrische Feldstärken von etwa 1.5-2 kV/cm in den Kanälen des Wabenkörpers sind dabei in der Regel ausreichend, um in den Kanälen ein Plasma zu erzeugen, das abgelagerte Russpartikel in gasförmige Substanzen umwandelt. Bei geschlossenen Filtern kann eine vorherige Aufladung der Russpartikel unterbleiben, da die Russpartikel im Zuge des Durchtritts des Abgases durch die Kanalwand in einen daneben liegenden Kanal mit offener Austrittsöffnung zurück gehalten werden. Diese Art der Abscheidung wird im Folgenden auch als "mechanische Abscheidung" bezeichnet. Der keramische Werkstoff ist hierzu porös ausgeführt, um einen Durchtritt des Abgases zu ermöglichen. Bei offenen Systemen wird der keramische Werkstoff im Zuge der Herstellung hingegen "dicht gebrannt", d.h., dass der Porenanteil gering ist, und es sich bei den verbleibenden Poren um geschlossene Poren handelt, also keinen Durchtritt von Abgas von einem Kanal in einen daneben liegenden Kanal ermöglichen. Als Werkstoff für den keramischen Wabenkörper finden in der Regel oxidische Keramiken Anwendung, insbesondere Kordierit.

Der Wabenkörper wird in der Regel entweder als kreisringzylindrischer Körper ausgeführt, in dessen innerem Hohlraum eine erste Elektrode angeordnet ist, zumeist jene mit der Hochspannungszuführung, und an dessen äußerem Umfang eine zweite Elektrode angebracht ist, zumeist jene, die auf Masse liegt, oder mit einer planaren Geometrie, also mit rechteckförmigem Querschnitt, an dessen gegenüber liegenden Seiten die beiden Elektroden angeordnet sind. Wahlweise kann auch eine "Sandwichstruktur" gewählt werden, bei der mehrere Elektrodenflächen den Wabenkörper durchziehen, wobei jeweils benachbarte Elektroden unterschiedliche Polarität aufweisen. Die Länge des Wabenkörpers, also die Erstreckung zwischen Eintrittsseite des Abgases in den Wabenkörper und der Austrittsseite, hängt im Wesentlichen von der notwendigen Verweildauer des Abgases im Wabenkörper ab, um einen vorgegebene Abscheidegrad für die Russpartikel sicher zu stellen. Diese Größe ist wiederum durch den Abgasvolumenstrom im Volllastbetrieb des Fahrzeugs bestimmt, also letztendlich auch vom Fahrzeugtyp abhängig. Die notwendige Verweildauer des Abgases in den Kanälen des Wabenkörpers ist selbstverständlich auch vom Abscheideverhalten der Russpartikel abhängig, die etwa durch die angelegte Feldstärke steuerbar ist, aber auch von der strukturellen Ausführung der Kanäle, also von der Wahl von Kanalhöhe und Kanalbreite.

Die vorliegende Erfindung bezieht sich auf eine besondere Filteranordnung, bei der vor dem keramischen Wabenkörper, der im Folgenden einfach als Keramikkörper bezeichnet wird, eine Entladungselektrode angeordnet ist, in der eine Aufladung der Russpartikel erfolgt, wie z.B. in der US 2004/141890 gezeigt. Das im nachfolgenden Keramikkörper angelegte elektrische Feld erfüllt daher nicht nur die Funktion des Russabbrandes, sondern auch die Funktion der Abscheidung der Russpartikel, wobei es im Falle der Wall-flow-Filter die mechanische Abscheidung unterstützt. Das im nachfolgenden Keramikkörper angelegte elektrische Feld wird im Folgenden daher auch als "Abscheidefeld" bezeichnet. Wie der Anmelder zeigen konnte, können mit einer solchen Filteranordnung Abscheidegrade bis zu 100% erreicht werden.

Gemäß dem Stand der Technik wird zur Erzielung bestmöglicher Abscheidegrade lediglich versucht, die Spannung am Keramikkörper so hoch wie möglich zu wählen, um die Abscheidung und den Abbrand des Rußes in den Kanälen des Keramikkörpers zu begünstigen. Bestenfalls wird eine Steuerung des Abscheidefeldes in Abhängigkeit von motorbezogenen Daten wie Temperatur des Abgasstromes und Einspritzmenge des Treibstoffs, oder Daten aus der Luftmengenmessung und der Abgasrückführung vorgenommen, sowie eine Spannungsbegrenzung überwacht, um das Bordnetz nicht zu überlasten. Diese Steuerung wird durch prozessorgesteuerte Bordsysteme übernommen, die in erster Linie für die Motorsteuerung verantwortlich sind. Eine *Regelung* des Abscheidefeldes erfolgt hingegen nicht, insbesondere wurde noch nicht daran gedacht, das Abscheidefeld anhand eigener, am Keramikkörper selbst bestimmter Regelvariable zu regeln, und somit eine von der Motorsteuerung autarke Regelung des Filters zu verwirklichen. Das ist darauf zurückzuführen, dass bislang davon ausgegangen wurde, dass für eine solche Regelung keine Notwendigkeit besteht, da, wie bereits erwähnt, stets versucht wurde das Abscheidefeld zu maximieren.

Es hat sich aber gezeigt, dass insbesondere bei vorheriger Aufladung der Russpartikel die Abscheidung dermaßen effektiv vollzogen werden kann, dass eine Maximierung des Abscheidefeldes sogar nachteilig werden kann, wie noch näher ausgeführt werden wird. Somit arbeiten bekannte Filtersysteme nicht nur ineffizient, sondern beeinträchtigen auch die Zeitstandsfestigkeit und Betriebssicherheit des Filtersystems. Da eine Regelung der an den Keramikkörper und an die Entladungselektrode angelegten Spannungen bislang nicht in Betracht gezogen wurde, fehlen auch Anhaltspunkte, wie eine solche Regelung vorgenommen werden könnte.

Es ist daher das Ziel der Erfindung, Verfahren für den Betrieb einer Filteranordnung zum Abscheiden von Russpartikel aus dem Abgasstrom eines Dieselmotors vorzuschlagen, die das Abscheide- und Abbrandverhalten des Filters optimieren, die Zeitstandsfestigkeit und die Betriebssicherheit der Filteranordnung erhöhen, und dabei einfach und stabil durchgeführt werden können.

Diese Ziele werden durch die Merkmale von Anspruch 1 erreicht. Anspruch 1 bezieht sich auf ein Verfahren für den Betrieb einer Filteranordnung zum Abscheiden von Russpartikel aus dem Abgasstrom eines Dieselmotors, bei dem der Abgasstrom durch in Längsrichtung eines Keramikkörpers verlaufende Kanäle des Keramikkörpers hindurchgeleitet wird, und an parallel zu den Kanälen verlaufenden Elektroden eine Spannung an den Keramikkörper zur Erzeugung eines elektrischen Abscheidefeldes in den Kanälen des Keramikkörpers, das jeweils quer zur Achse der Kanäle orientiert ist, angelegt wird. Erfindungsgemäß ist dabei vorgesehen, dass vor dem Einleiten des Abgasstroms in die Kanäle des Keramikkörpers eine Aufladung der Russpartikel mithilfe einer Entladungselektrode erfolgt, und es sich bei jener Spannung, die an den parallel zu den Kanälen verlaufenden Elektroden angelegt wird, um Spannungsimpulse handelt, wobei die Spannungsimpulse in Abhängigkeit von der Strömungsgeschwindigkeit, mit der der Abgasstrom die Filteranordnung durchströmt, geregelt werden.

Die Strömungsgeschwindigkeit in den Kanälen des Keramikkörpers ist dabei bei genauer Betrachtung eine komplexe Größe, da etwa im Einlaufteil der Kanäle turbulente Strömung herrscht, in der eine Strömungsgeschwindigkeit nicht so zu definieren ist wie in jenem Abschnitt der Kanäle, in denen sich letztendlich eine laminare Strömung einstellt. Des Weiteren wird sich innerhalb der Kanäle jeweils ein Strömungsprofil entlang des Querschnitts der Kanäle, sowie ein, wenn auch kleiner, Beschleunigungsweg des Abgasstroms einstellen. Für eine erfindungsgemäße Regelung ist jedoch von einer *Messgröße* auszugehen, die die für die Regelung relevante Strömungsgeschwindigkeit des Abgasstroms in den Kanälen des Keramikkörpers wiedergibt. Diese Messgröße ist etwa über Messung des Differenzdrucks an der Einlaufseite und an der Auslaufseite der Kanäle leicht zu gewinnen. Alternativ zur Strömungsgeschwindigkeit des Abgasstroms in den Kanälen des Keramikkörpers könnte auch die Strömungsgeschwindigkeit des Abgasstroms durch die Entladungselektrode herangezogen werden. Diese beiden Strömungsgeschwindigkeiten kennzeichnen letztendlich dieselbe physikalische Größe, und variieren lediglich aufgrund der unterschiedlichen geometrischen Gegebenheiten innerhalb der Entladungselektrode und der Kanäle des Keramikkörpers.

Da ferner die Strömungsgeschwindigkeit auch von der Menge des abgelagerten Rußes sowie vom Abbrand des Rußes abhängt, die wiederum jeweils von der Größe der Spannungsimpulse abhängen, handelt es sich hierbei um eine echte Regelung. Die Messung, etwa über Drucksensoren auf der Eintritts- und Austrittsseite des Keramikkörpers, und die Verarbeitung der Messsignale kann über einen eigenen, dem Keramikkörper zugeordneten Prozessor vorgenommen werden, und erfolgt in diesem Fall autark von den übrigen, prozessorgesteuerten Bordsystemen. Das ermöglicht einerseits eine Echtzeit-Regelung, die rasch auf unterschiedliche Fahrtsituationen angepasst werden kann, und andererseits auch eine einfache und somit stabile Regelung, da keine Abhängigkeit von den zumeist komplexen Motorsteuerungsprozessen besteht. Eine rasche Regelung ist vor allem auch deshalb wichtig, da aufgrund der auf der Hochspannungsseite auftretenden Kapazitäten das Abscheidefeld ohnehin nur relativ langsam regelbar ist, und durch rasche Regelung rechtzeitig auf den neuen Russanfall eingestellt werden kann. Die Größe der Spannungsimpulse bestimmt sich in erster Linie über die für eine zuverlässige Abscheidung der Russpartikel notwendige, mittlere Feldstärke des Abscheidefeldes innerhalb der Kanäle, und hängt daher auch vom verwendeten Filtertyp ab, also ob etwa ein offener oder ein Wall-flow-Filter verwendet wird, wie später anhand unterschiedlicher Ausführungsbeispiele noch genauer erläutert wird.

Gemäß Anspruch 2 ist vorgesehen, dass zur Regelung der Spannungsimpulse die Strömungsgeschwindigkeit in zumindest zwei Intervalle unterteilt wird, wobei in zumindest einem Intervall der niedrigsten Strömungsgeschwindigkeiten eine in Abhängigkeit vom zeitlichen Differential der Strömungsgeschwindigkeit unterschiedliche Regelung vorgenommen wird, und im Intervall der höchsten Strömungsgeschwindigkeiten die Regelung der Spannungsimpulse proportional zur Strömungsgeschwindigkeit erfolgt. Eine genaue Analyse des Abscheide- und Abbrandverhaltens im Keramikkörper zeigt nämlich, dass in den unteren Leistungsbereichen eine von den höheren Leistungsbereichen abweichende Regelung vorteilhaft ist. So ist es etwa vorteilhaft gemäß Anspruch 3 vorteilhaft, bei negativem zeitlichen Differential der Strömungsgeschwindigkeit eine auf den Abbrand des Rußes optimierte Regelung der Spannungsimpulse unter Maximierung des Abscheidefeldes vorzunehmen, und bei positivem zeitlichen Differential oder Verschwinden des Differentials der Strömungsgeschwindigkeit eine auf die Abscheidung und Verteilung des Rußes optimierte Regelung der Spannungsimpulse unter Minimierung des Abscheidefeldes vorzunehmen. Ein negatives zeitliches Differential der Strömungsgeschwindigkeit in den unteren Leistungsbereichen entspricht etwa einer Fahrtsituation, bei der der Fahrer bei ohnehin geringer Motorleistung die Geschwindigkeit reduziert. In diesem Fall fällt geringe Russmenge bei guter Sauerstoffanreicherung an. Eine solche Situation eignet sich gut für eine Regeneration des Filters, bei der also der Abbrand des Rußes im Vordergrund steht, und nicht dessen Abscheidung. Hierzu ist das Abscheidefeld zu maximieren. Ein positives zeitliches Differential der Strömungsgeschwindigkeit in den unteren Leistungsbereichen entspricht etwa einer Fahrtsituation, bei der der Fahrer bei ohnehin geringer Motorleistung die Geschwindigkeit erhöht. In diesem Fall fällt eine größere Russmenge an, die aber leicht abgeschieden werden kann, da die Abscheideleistung des Filters auf Volllastbetrieb ausgelegt ist. In dieser Situation ist darauf Rücksicht zu nehmen, dass das Abscheidefeld nicht zu hoch gewählt wird, da sich ansonsten die Abscheidung des Rußes auf den Einlaufbereich der Kanäle konzentriert, was einem nachträglichen Abbrand des Rußes und somit der Lebensdauer des Filters abträglich ist. Um die Abscheidung des Rußes auf die gesamte Kanallänge zu verteilen, ist somit das Abscheidefeld zu minimieren, wobei selbstverständlich eine zuverlässige Abscheidung des Rußes in den Kanälen des Keramikkörpers aufrecht zu erhalten ist. Auch auf diese Art der Regelung wird im Folgenden anhand verschiedener Ausführungsbeispiele noch näher eingegangen.

Anspruch 4 sieht vor, dass eine mit dem zeitlichen Differential der Strömungsgeschwindigkeit korrelierte Regelgröße durch Differenzbildung zweier aufeinander folgender Messwerte für eine mit dem Abgasmassenstrom korrelierte Größe, etwa der Strömungsgeschwindigkeit, bestimmt wird. Dabei wird gemäß Anspruch 5 bei Überschreiten eines vorgegebenen, positiven Wertes für das zeitliche Differential der Strömungsgeschwindigkeit, oder einer mit ihr korrelierten Regelgröße, eine, lediglich mit einem vorgegebenen Maximalwert begrenzte, überproportionale Regelung des Abscheidefeldes vorgenommen. Anspruch 6 sieht vor, dass die Strömungsgeschwindigkeit (v), oder eine mit ihr korrelierte Regelgröße, gemeinsam mit dem dazugehörenden Abscheidefeld (E) als eine mindestens zweispaltige Regeltabelle in einen Prozessor eingelesen und verarbeitet wird, wobei gegebenenfalls weitere Spalten der Regeltabelle für weitere Regelgrößen, wie etwa der Temperatur des Abgases, sowie die dazugehörenden Stellwerte für das Abscheidefeld (E) vorgesehen sind.

Anspruch 7 sieht vor, dass der Ladestrom während eines Spannungsimpulses gemessen wird, und die Spannungsimpulse so geregelt werden, dass das Produkt aus dem maximalen Wert der Spannungsimpulse und dem Ladestrom unterhalb eines vorgegebenen Wertes liegt. Diese Maßnahme dient einerseits zum Schutz der Filterelektronik sowie des Bordnetzes, andererseits aber auch dem Schutz des Keramikkörpers. Der Keramikkörper verhält sich nämlich bei Aufladung durch die Spannungsimpulse wie eine Kapazität, die durch die zunehmende Leitfähigkeit des Rußes eine Temperaturabhängigkeit zeigt, und durch die mit der Temperatur zunehmende ohmsche Leitfähigkeit der Keramik auch rascher entladen wird. Der Ladestrom nimmt daher bei zunehmender Temperatur des Keramikkörpers zu, sodass auch die Leistungsaufnahme ohne Begrenzung unzulässige Werte erreichen würde. Andererseits droht bei zunehmender Temperatur des Keramikkörpers auch ein Spannungsdurchschlag, der den Keramikkörper schädigen könnte. Durch die Maßnahme der Begrenzung des Produkts aus dem maximalen Wert der Spannungsimpulse und dem Ladestrom können diese negativen Folgen verhindert werden.

Insbesondere kann gemäß Anspruch 8 vorgesehen sein, dass der vorgegebene Wert aus dem Produkt des maximalen Wertes der Spannungsimpulse und des maximalen Wertes für den Ladestrom gebildet wird, wobei der maximale Wert der Spannungsimpulse und der maximale Wert für den Ladestrom für unterschiedliche Intervalle der Strömungsgeschwindigkeit unterschiedlich gewählt werden, aber das Produkt jeweils konstant ist. Die Strömungsgeschwindigkeit ist nämlich ein Indikator für die Abgastemperatur und die Temperatur des Keramikkörpers, da höhere Strömungsgeschwindigkeiten bei höheren Motorleistungen auftreten. Durch diese Maßnahme werden die oben beschriebenen, negativen Folgen für die Filterelektronik und den Keramikkörper wiederum unterbunden, wobei der maximale Wert für die Spannungsimpulse und der maximale Wert des Ladestromes für unterschiedliche Intervalle der Strömungsgeschwindigkeit unterschiedlich gewählt werden können. Das heißt, dass etwa bei Überschreiten einer bestimmten Strömungsgeschwindigkeit, und somit bei Überschreiten einer bestimmten Temperatur des Abgasstromes bzw. des Keramikkörpers, der maximal zulässige Wert für die Spannungsimpulse abgesenkt wird, und der maximale Wert für den Ladestrom erhöht wird, wobei jedoch ihr Produkt jeweils konstant bleibt. Das ermöglicht eine besonders effektive Regelung der Spannungsimpulse bei zunehmenden Temperaturen.

Anspruch 9 bezieht sich auf Maßnahmen, die nach dem Start des Dieselmotors getroffen werden. So wird vorgeschlagen, dass nach dem Start des Dieselmotors der maximale Wert der Spannungsimpulse schrittweise auf die für den Dauerlastbetrieb vorgesehene Betriebsspannung erhöht wird, wobei bei jedem Schritt der Spannungserhöhung eine Messung des Ladestromes vorgenommen wird, und eine Erhöhung des maximalen Werts der Spannungsimpulse erst dann erfolgt, wenn der Ladestrom unterhalb einer vorgegebenen Größe verbleibt. Im Tieftemperaturbereich ist nämlich der Nachweis von Kondenswasser im Keramikkörper besonders wichtig, da dies zu elektrischen Überschlägen führt, die einerseits Stickoxide bilden, und andererseits den Keramikkörper und die keramischen Hochspannungszuführungen zerstören können. Daher wird vorgeschlagen, dass nach dem Startvorgang die Spannung am Keramikkörper zunächst auf einen niedrigen Wert unterhalb der vorgesehenen Betriebsspannung hochgefahren wird, und der Ladestrom gemessen wird. Ist für diese erste, niedrige Spannung der Ladestrom oberhalb eines vorgegebenen Grenzwertes, so wird die Spannung für eine vorgegebene Zeit zunächst auf diesem niedrigen Wert gehalten. Danach wird die Spannung nach einer vorgegebenen Zeit etwa auf einen höheren Spannungswert erhöht, und wiederum der Ladestrom gemessen. Falls der Ladestrom wiederum oberhalb des vorgegebenen Wertes liegt, wird die Spannung wieder auf den vorangegangenen Wert zurückgefahren. Erst wenn der Ladestrom unterhalb des vorgegebenen Wertes verbleibt, wird die Spannung auf dem nächst höheren Spannungswert gehalten. Dieser Wert kann bereits die vorgesehen Betriebsspannung sein, oder es werden weitere Schritte der Spannungserhöhung vorgenommen.

Eine Analyse des unmittelbar nach dem Start des Dieselmotors freigesetzten Abgasstromes zeigt allerdings, dass er zunächst eine hohe Konzentration an Russpartikel enthält, die bei herkömmlichen Kraftfahrzeugen als dunkle "Startwolke" zumeist auch deutlich sichtbar ist, und eventuell auftretendes Kondenswasser erst danach im Abgasstrom auftritt. Daher wird gemäß Anspruch 10 vorgeschlagen, dass unmittelbar nach dem Start des Dieselmotors der maximale Wert der Spannungsimpulse zunächst der für den Dauerlastbetrieb vorgesehenen Betriebsspannung entspricht, und erst nach einer vorgegebenen Zeitdauer eine Absenkung des maximalen Werts der Spannungsimpulse auf einen Wert unterhalb der für den Dauerlastbetrieb vorgesehenen Betriebsspannung und eine anschließende, schrittweise Erhöhung nach Anspruch 9 erfolgt. Mithilfe dieser Maßnahmen wird erreicht, dass für die unmittelbar nach dem Start auftretende, hohe Konzentration an Ruß im Abgasstrom eine gute Abscheidung erreicht wird, und erst danach eine auf eventuell auftretendes Kondenswasser im Abgasstrang Rücksicht nehmende Regelung vorgenommen wird. Die vorgegebene Zeitdauer bis zur Absenkung der Spannungsimpulse hängt vom jeweiligen Motor und dem Ort des Filters ab, wird jedoch im Bereich weniger Sekunden liegen.

Anspruch 11 bezieht sich auf Maßnahmen zur Regelung der Spannung, die an die Entladungselektrode angelegt wird, und sieht vor, dass es sich dabei ebenfalls um Spannungsimpulse handelt, wobei die Spannungsimpulse in Abhängigkeit von der Strömungsgeschwindigkeit, mit der der Abgasstrom die Filteranordnung durchströmt, geregelt werden. Zur Regelung der Spannungsimpulse an der Entladungselektrode könnte wiederum die Strömungsgeschwindigkeit, mit der der Abgasstrom die Kanäle des Keramikkörpers durchströmt, herangezogen werden, oder jene Strömungsgeschwindigkeit, mit der der Abgasstrom die Entladungselektrode durchströmt.

Die Ansprüche 12, 13 und 14 beziehen sich auf Maßnahmen zum Schutz der Entladungselektrode. So sieht Anspruch 12 vor, dass der Ladestrom während eines Spannungsimpulses an der Entladungselektrode gemessen wird, und die Spannungsimpulse so geregelt werden, dass dieser Ladestrom der Entladungselektrode unterhalb eines vorgegebenen Maximalwertes liegt. Insbesondere kann gemäß Anspruch 13 vorgesehen sein, dass der vorgegebene Maximalwert für den Ladestrom der Entladungselektrode bei Überschreiten einer vorgegebenen Strömungsgeschwindigkeit, mit der der Abgasstrom die Filteranordnung durchströmt, abgesenkt wird. Die Strömungsgeschwindigkeit des Abgasstromes etwa innerhalb der Entladungselektrode ist wiederum ein Indikator für die Abgastemperatur und die Temperatur der Entladungselektrode, da höhere Strömungsgeschwindigkeiten bei höheren Motorleistungen auftreten. Diese Maßnahme dient deshalb dem Schutz der Entladungselektrode, da andernfalls die üblicherweise verwendeten Elektroden bei höheren Temperaturen instabil werden, und letztendlich beschädigt werden können.

Die Merkmale von Anspruch 14 dienen nicht nur zur Erhöhung der Zeitstandsfestigkeit der Entladungselektrode durch eine Reduktion der Entladungsstärke auf den gerade zur Aufladung der Partikel notwendigen Entladungsstrom, sondern auch zur Reduktion der Belastung des Bordnetzes. Anspruch 15 führt Anspruch 14 durch eine Verfeinerung der Erfassung des tatsächlich emittierten Rußes in der Regelung des Entladungsstromes fort, indem auch Abgasrückführung und Konzentration des Restsauerstoffes, die beide den Russgehalt des Abgases beeinflussen, in die Regelung einbezogen werden.

Des Weiteren kann vorgesehen sein, dass eine Differenzbildung zweier aufeinander folgender Messwerte für eine mit dem Russmassenstrom (RMS) korrelierten Größe, wie etwa der Gaspedalstellung oder der Einspritzmenge an Dieselöl, vorgenommen wird, und für den Fall, dass diese Differenz eine festgelegte Schranke (S) übersteigt, also

$$(RMS_n) - (RMS_{n-1}) > S,$$

eine überproportionale Regelung des Entladungsstromes ($i_e$) zum Russmassenstrom (RMS) erfolgt. Des Weitern kann vorgesehen sein, dass im Falle einer überproportionalen Regelung des Entladungsstromes annähernd gleichzeitig eine überproportionale Regelung des Abscheidefeldes stattfindet, wobei vorzugsweise das Abscheidefeld auf den erlaubten Maximalwert gestellt wird.

Nach einer überproportionalen Regelung des Entladungsstromes zum Russmassenstrom der Entladungsstrom kann innerhalb von 20 Sekunden, vorzugsweise innerhalb von 10 Sekunden, auf die zum Russmassenstrom proportionale Größe reduziert werden. Somit kann entsprechend vorgesehen sein, dass nach einer überproportionalen Regelung des Entladungsstromes zum Russmassenstrom das Abscheidefeld näherungsweise gleichzeitig mit dem Entladungsstrom innerhalb von 20 Sekunden, vorzugsweise innerhalb von 10 Sekunden, auf die zur Strömungsgeschwindigkeit proportionale Größe reduziert wird.

Schließlich kann vorgesehen sein, dass eine Differenzbildung zweier aufeinander folgender Messwerte für eine mit dem Russmassenstrom (RMS) korrelierten Größe, wie etwa der Gaspedalstellung oder der Einspritzmenge an Dieselöl, vorgenommen wird, und für den Fall, dass diese Differenz über einen festgelegten Zeitraum eine festgelegte Schranke (s) unterschreitet, also bei

$$(RMS_n) - (RMS_{n-1}) < s,$$

der Entladungsstrom ($i_e$) um 10% bis 30% reduziert wird, und nach einem vorgegebenen Zeitraum wieder auf den ursprünglichen Wert angehoben wird.

Die Erfindung wird im Folgenden anhand verschiedener Ausführungsbeispiele mithilfe der beiliegenden Figuren näher erläutert. Es zeigen hierbei die

Fig. 1 eine schematische Darstellung eines Querschnitts eines Keramikkörpers zur Entfernung von Russpartikel aus einem Abgasstrom,

Fig. 2 eine Detailansicht von Fig. 1, wobei insbesondere die Anordnung der Kanäle ersichtlich ist, und

Fig. 3 eine Darstellung zur Erläuterung der Geschwindigkeitskomponenten des Abgasstromes in einem Kanal des Keramikkörpers.

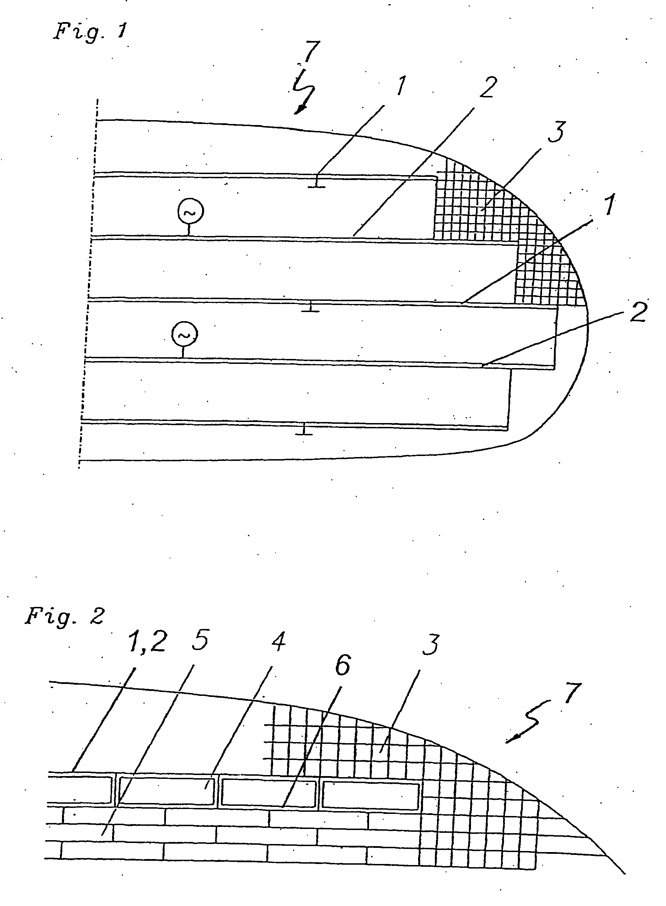

Die Fig. 1 und 2 zeigen jeweils eine schematische Darstellung eines Querschnitts eines Keramikkörpers 7, bei dem es sich um einen Wabenkörper handelt. Dabei ist jeweils ein Keramikkörper 7 mit konvexer, nämlich elliptischer Umfangslinie dargestellt, er könnte aber auch andere Querschnittsformen aufweisen, etwa eine Trapezform. Der Keramikkörper 7 weist Kanäle 5 auf, die in Längsrichtung des Keramikkörpers 7 verlaufen. Bei einem "offenen Filter" sind die Kanäle 5 beidseitig offen, während bei einem "Wall-flow-Filter" die Kanäle 5 an einer Stirnseite des Keramikkörpers 7 offen sind, und an der jeweils gegenüberliegenden Seite geschlossen. Somit tritt der Abgasstrom bei diesem Filtertyp durch einen an der Eintrittsseite offenen, aber an dessen Austrittsseite verschlossenen Kanal 5 ein, und muss zum Verlassen des Keramikkörpers 7 durch die Innenwand des betreffenden Kanals 5 zum benachbarten Kanal 5, der an der Eintrittsseite verschlossen, aber an der Austrittsseite offen ist, hindurch treten.

Gemäß der Ausführungsform der Fig. 1 und 2 werden die Elektroden 1,2 jeweils durch eine Gruppe von Elektrodenkanälen 4, in denen jeweils zumindest teilweise entlang ihrer axialen Erstreckung eine elektrische Beschichtung 6 eingebracht ist, gebildet. Wie insbesondere aus der Fig. 2 ersichtlich ist, werden die Gruppen von Elektrodenkanälen 4 jeweils durch nebeneinander liegende Elektrodenkanäle 4 gebildet, sodass durch jede Gruppe von Elektrodenkanälen 4 eine ebene Elektrodenfläche 1,2 definiert wird. Es sind aber auch andere Ausführungen der Elektroden möglich.

Wie aus der Fig. 1 ersichtlich ist, verlaufen die ebenen Elektrodenflächen 1,2 jeweils horizontal und parallel zueinander. Der Abstand zweier benachbarter Elektrodenflächen 1 und 2 beträgt vorzugsweise weniger als 40 mm, etwa 15-25 mm. Dadurch kann zwischen den Elektrodenflächen 1 und 2 ein homogenes elektrisches Feld sichergestellt werden, und zwar insbesondere in jenen Raumbereichen, die sich innerhalb des von jeweils zwei benachbarten Elektrodenflächen 1,2 begrenzten Raumbereiches des Keramikkörpers 7 befinden, der im folgenden auch als homogener Feldbereich bezeichnet wird. Der außerhalb des homogenen Feldbereiches liegende Bereich 3 des Keramikkörpers 7 verfügt in der Ausführungsform gemäß der Fig. 1 und 2 über eine dichtere Struktur, um deren strukturelle Belastbarkeit zusätzlich zu erhöhen.

Zwei benachbarte Elektrodenflächen 1 und 2 sind jeweils gegenpolig kontaktiert, wobei in der Fig. 1 etwa die Elektrodenfläche 1 geerdet ist, und die Elektrodenfläche 2 mit bipolaren Spannungsimpulsen versorgt wird.

Die erfindungsgemäßen Regelungen der Spannungsimpulse am Keramikkörper 7 werden im Folgenden anhand verschiedener Ausführungsformen näher erläutert. Hierbei wird zunächst auf den "offenen" Filter eingegangen, sowie anschließend auf den "Wall-flow-Filter", wobei bei letzterem Regelungen des Abscheidefeldes im Keramikkörper 7 bei zwei unterschiedlichen, in der Praxis besonders vorteilhaften Betriebsarten erläutert werden sollen, die beide eine besonders gute Zeitstandsfestigkeit der Filteranordnung ermöglichen, indem sie ein Verstopfen der Poren des Keramikkörpers wirkungsvoll verzögern.

Offener Filter:

Ein moderner offener Russfilter, bei dem die Russpartikel durch eine Gasentladung einer mit unipolaren Spannungsimpulsen aufgeladenen Entladungselektrode geleitet werden, die dadurch aufgeladenen Russpartikel mit Hilfe eines elektrischen Abscheidefeldes E in einem nachfolgenden Keramikkörper 7 abscheidet, das ebenfalls mit Hilfe unipolarer Spannungsimpulse errichtet wird, ihn gleichsam elektrisch "schließt", und mit eben diesem Abscheidefeld E das unipolare Plasma erzeugt, mit dessen Hilfe der Filter regeneriert wird, hat große Chancen, herkömmliche Systeme abzulösen. Ausschlaggebend dafür sind der im offenen Keramikkörper 7 fehlende Druckaufbau im Vergleich zum "Wallflow-Filter", die unbegrenzte Zeitstandsfestigkeit (Kilometerleistung), sowie die deutlich tiefere Temperatur, bei der dieses System regenerieren kann.

Diese Filtersysteme zeichnen sich vor allem dadurch aus, dass die Russpartikel vor ihrer Abscheidung durch ein Entladungsgefäß, das die Entladungselektrode enthält, geleitet werden, in dem eine unipolare Gasentladung die Partikel bis in die Nähe ihrer Sättigungsaufladung negativ auflädt. Durch diese Aufladung ist es nicht nur erst möglich, die Russpartikel in dem elektrischen Abscheidefeld E abzuscheiden, das in dem nach der Gasentladung angeordneten Keramikkörper 7 errichtet ist, sondern durch diese unipolare Entladung wird der stark elektronegative Sauerstoff an die Partikel gebunden, der teilweise bereits im negativ aufgeladenen Zustand vorliegt, oder sich bei Stößen mit den negativ geladenen Russteilchen bevorzugt anlagert.

Daher müssen in jedem Filter zwei Gasentladungen durch eine elektronische Regelung stabil gehalten, oder den sich ändernden Gasparametern angepasst werden. Diese Gasentladungen werden nicht nur durch die Temperatur und Feuchte des Abgasstromes, sondern auch durch seine chemische Zusammensetzung beeinflusst. Insbesondere der Gehalt des Abgases an Restsauerstoff, der durch die Einspritzmenge, die zugeführte Frischluft und die Abgasrückführung (AGR) während des Fahrbetriebes starken Schwankungen unterworfen ist, macht eine schnelle Regelung der Entladungsspannung notwendig, da alle diese Gasentladungen über die Ionisation des Sauerstoffs laufen, der das geringste Ionisationspotential aller in dem Abgas vorkommenden Gase besitzt.

Im nachfolgenden Keramikkörper 7 finden schließlich die Abscheidung und der Abbrand der abgeschiedenen Russpartikel statt. Für eine zuverlässige Abscheidung der Russpartikel in den Kanälen 5 des Keramikkörpers 7 muss das Verhältnis der Driftgeschwindigkeit c(d) für alle elektrisch aufgeladenen Russteilchen im mittleren Abscheidefeld E in Richtung des elektrischen Feldes zu einer Kanalwand zu der Kanalhöhe h in Feldrichtung größer oder gleich dem Verhältnis der mittleren Strömungsgeschwindigkeit v im Kanal 5 zur Kanallänge L sein, also

$$c(d)/h \geq v/L$$

Mit dieser Bedingung "schließt" das Abscheidefeld E den Filter, und es können Abscheidegrade bis zu 100% erreicht werden. Bei Sättigungsaufladung gilt das Gleichheitszeichen, weicht die Aufladung von ihrer möglichen Sättigung ab, so gilt das "größer"-Zeichen.

Im ungünstigsten Fall tritt ein Russpartikel unmittelbar an einer Wand in den Kanal 5 des Keramikkörpers 7 ein, und soll auf der gegenüberliegenden Wand abgeschieden werden. Während also das Abgas den Kanal 5 des Keramikkörpers 7 der Länge L mit der Strömungsgeschwindigkeit v durchströmt, muss das geladene Russteilchen unter dem Abscheidefeld E mit der Geschwindigkeit c, die von seinem Durchmesser d abhängt, in Richtung der gegenüberliegenden Wand driften, und sie vor dem Austritt des Abgases aus dem Kanal 5 erreichen. Dazu hat das Teilchen die Zeit t, die es sich im Kanal 5 aufhält:

$$t = L/v$$

Da das Teilchen in dieser Zeit mindestens die Kanalhöhe h zurücklegen muss, ergibt sich bei vorgegebener Driftgeschwindigkeit c(d), mit der Beweglichkeit $\kappa(d)$, der Ladungszahl z(d), die alle von dem Partikeldurchmesser d abhängen, und der mittleren Abscheidefeldstärke E senkrecht auf die Kanalachse die Driftgeschwindigkeit für Russteilchen mit dem Durchmesser d:

$$c(d) = \kappa(d).z(d).E$$

Als untere Abschätzung für eine vollkommene Abscheidung im Filter ergibt sich daher die Beziehung

$$t.c(d) \geq h$$

oder

$$\kappa(d).z(d).E \geq h.v/L$$

oder

$$\kappa(d).z(d).E/h \geq v/L$$

Somit muss die Driftgeschwindigkeit c(d) aller aufgeladenen Russteilchen mit dem Durchmesser d in Feldrichtung gebrochen durch die Kanalhöhe h also größer sein, als die mittlere Geschwindigkeit des Abgases v gebrochen durch die Kanallänge L.

Tabelle 1 zeigt den spektralen Durchlass bei verschiedenen Partikeldurchmessern d für einen sehr realistischen Fall. Ein Gesamtquerschnitt des Keramikkörpers 7 von 360 cm$^2$ mit 0,6 mm Kanalhöhe h und 3 mm Kanalbreite b muss mit einem mittleren Abscheidefeld E von 3 kV/cm einen Abgasmassenstrom von 500 kg/h bei einer Abgastemperatur 500°C bewältigen. Die obige Ungleichung wurde umgeformt und lautet nun in etwas anderer Form

$$\kappa(d).z(d).E.L/h.v \geq 1$$

Diese Ungleichung muss erfüllt sein, wenn 100% aller Russpartikel in dem offenen Filter mit einer Länge von L = 250 mm und der Kanalhöhe von h = 0,6 mm mit einem Abscheidefeld E von 3 kV/cm abgeschieden werden sollen. Es ist ersichtlich, dass die Ungleichung nur für die Partikelgröße mit dem Durchmesser d = 100 nm verletzt wird, der nicht mehr zur Partikelzahl und noch nicht zur Partikelmasse der Emission relevant ist.

Tabelle 1 zeigt den spektralen Durchlass unterschiedlicher Partikelgrößen:

Tabelle 1:

| d | $\kappa(d).z(d).E$ (E = 3 kV/cm) | $\kappa(d).z(d).E/h$ (h = 0,6 mm) | $\kappa(d).z(d).E.L/h.v$ ($\geq$ 1) | Spektraler Durchlass |
|---|---|---|---|---|
| 10 nm | 5,7 cm/s | 95 | 1,56 | 0% |
| 20 nm | 3,9 cm/s | 65 | 1,07 | 0% |
| 100 nm | 3,0 cm/s | 50 | 0,82 | 18% |
| 1 $\mu$m | 4,8 cm/s | 80 | 1,31 | 0% |
| 10 $\mu$m | 18,0 cm/s | 300 | 4,92 | 0% |

Aus der Tabelle 1 lässt sich ablesen, dass die Größe $\kappa(d).z(d).E.L/h.v$ größer oder gleich 1 sein muss, um eine quantitative Abscheidung des Rußes im Keramikkörper 7 zu erzielen. Der spektrale Durchlass ist effektiv und bezieht sich nur auf die Teilchenzahl der Partikel mit der angegebenen Größe.

In der Realität kann die Abscheidung von 100% dann nicht ganz erreicht werden, wenn die Aufladung der Partikel nicht der durch die Ladungszahl z beschriebenen entspricht, und wenn sich durch stark schwankende Betriebsweise die Einlauflänge in den Kanälen 5 ändert, da durch das sich verschiebende Abklingen der Einlaufturbulenz abgeschiedener Russ abgelöst werden kann.

Eine weitere Schwierigkeit bei der Erreichung möglicher Abscheidegrade zwischen 90% und 100% liegt in den sehr unterschiedlichen Betriebszuständen eines Verbrennungsmotors in einem Kraftfahrzeug. Wird der Filter auf eine möglichst hohe, vorzugsweise vollkommene Abscheidung im Volllastbereich ausgelegt, findet die Abscheidung im Niedriglastbereich bereits im Einlaufteil des Keramikkörpers 7 statt. Diese Schwierigkeit wird durch die heute sehr oft gewünschte Übermotorisierung besonders verschärft. Bei einem Mittelklassewagen, der von einem Dieselmotor mit 200 PS angetrieben wird, besteht sehr selten die Gelegenheit, diese Leistung über längere Zeit abzurufen. Statt einem Massenstrom von 500 kg/h wird das Fahrzeug dann im Stadtverkehr 100 kg/h selten überschreiten, was mit dem entsprechenden Temperaturunterschied zwischen Volllast und Teillast ein Verhältnis der Abgasvolumenströme von etwa 1:10 ergibt. Damit findet die Abscheidung des gesamten Rußes im Stadtverkehr in den ersten 10% der Länge des Keramikkörpers 7 statt. Da aber die Stärke der kontinuierlich laufenden Regeneration des Filters durch das in den Kanälen 5 ausgelöste, unipolare Plasma dann am größten ist, wenn sich der Russ über das ganze Filtervolumen verteilt, kann es im Niedriglastbereich zu Schwierigkeiten kommen, die bis zu einer Unterbrechung der Regeneration und anschließenden Blockade der Kanäle 5 führen kann.

Erfindungsgemäß werden diese Schwierigkeiten dadurch behoben, dass die Abscheidefeldstärke E proportional zu dem Abgasmassenstrom M bzw. dem Abgasvolumenstrom V geregelt wird, die wiederum proportional zur Strömungsgeschwindigkeit v in der Filteranordnung sind, und dass diese Regelung vorzugsweise nur über ein Intervall des Abscheidefeldes E und/oder der Strömungsgeschwindigkeit v erfolgt.

Bei dieser Regelung ist es sehr sinnvoll, die bei höheren Temperaturen T auch höhere Beweglichkeit $\kappa(d,T)$ zu berücksichtigen. Mit dem gesamten freien Querschnitt q aller Kanäle 5 und der Beziehung mit dem Abgasvolumenstrom V = q.v und der mittleren Gasgeschwindigkeit v in den Kanälen 5 ergibt sich aus der Beziehung

$$\kappa(d,T).z(d).E.L/h.v \geq 1$$

mit dem Gleichheitszeichen die Regelgleichung zwischen der Abscheidefeldstärke E und dem temperaturabhängigen Abgasvolumenstrom V(T) = q.v(T)

$$E(T) = h.V(T) / q.L.\kappa(d,T).z(d) \quad ... \quad \text{Gleichung (1)}$$

Wird das kleinste Produkt aus Beweglichkeit und Ladungszahl $\kappa(d).z(d)$ eingesetzt, also gemäß Tabelle 1 für den Partikeldurchmesser 100 nm, so werden Partikel dieser Größe bei exakter Erfüllung der Regelgleichung gerade noch am Ende des Kanals 5 abgeschieden.

Alternativ kann auch durch Verwendung der Beziehung

$$V(T) = q.v(T)$$

Die Gleichung (1) auch geschrieben werden als

$$E(T) = h.v(T) / L.\kappa(d,T).z(d) \quad ... \quad \text{Gleichung (2)}$$

Aus der so berechneten, erforderlichen Größe des Abscheidefeldes E folgt unmittelbar die erforderliche Höhe der Spannungsimpulse, die an den parallel zu den Kanälen 5 verlaufenden Elektroden anzulegen ist, wobei hierzu die jeweilige, strukturelle Ausführung des Keramikkörpers 7 und seine Materialeigenschaften zu berücksichtigen sind. Aus der Gleichung (2) ergibt sich somit die Regelung der Spannungsimpulse in Abhängigkeit von der Strömungsgeschwindigkeit v.

Wenn nun das Abscheidefeld E mit dem Gasvolumenstrom V und der vorzugsweisen Temperaturkorrektur V(T)/$\kappa(d,T)$ geregelt wird, ergibt sich die weitere Schwierigkeit, dass bei geringer werdender Abscheidefeldstärke E auch die Plasmatemperatur und damit die Regenerationsgeschwindigkeit geringer wird, und letztendlich die Konversion des Rußes ganz erlischt. Bei tiefen Temperaturen und hohem Russanfall darf das Abscheidefeld E daher nicht unter eine vorgegebene Schranke geregelt werden. Besonders gravierend wird dieses Problem bei kurzen Volllastbeschleunigungen mit einem durch längeren Teillastbetrieb kalten Motor.

Gemäß einer vorteilhaften Weiterbildung der Erfindung kann dieses Problem dadurch gelöst werden, dass bei hohem Russanfall ein entsprechend hohes Abscheidefeld E gesetzt wird, bei geringem Russanfall aber je nach Regenerationszustand des Filters zwischen hohem Feld und geringem Feld gewechselt wird, wobei vorzugsweise zu diesem Wechsel die Daten "hoher Russanfall" und "geringer Russanfall" sowie Gasmassenstrom aus dem Motorrechner über einen CANBUS an den Prozessor des Filters übertragen werden, oder der Wechsel wird direkt aus dem Motorrechner gesteuert, der dann Russmenge und Russverteilung im Filter selbst berechnet.

Ist v die mittlere Strömungsgeschwindigkeit des Abgases in den Kanälen 5 des Keramikkörpers 7, so ergibt sich das erfindungsgemäße Regelprinzip dadurch, dass man die Strömungsgeschwindigkeit v in mindestens zwei Intervalle teilt, wo für die größere Strömungsgeschwindigkeit die normale Regelgleichung gilt, die Abscheidefeldstärke E bzw. die Spannungsimpulse also proportional zur Strömungsgeschwindigkeit v geregelt werden, während für die geringere Strömungsgeschwindigkeit v nur die normale Regelgleichung gilt, wenn die Ableitung der Strömungsgeschwindigkeit v nach der Zeit positiv oder Null ist, also die Strömungsgeschwindigkeit v mit der Zeit zunimmt oder konstant bleibt. Ist dagegen die Ableitung der Strömungsgeschwindigkeit v nach der Zeit negativ, nimmt also die Strömungsgeschwindigkeit v mit der Zeit ab, so wird das Abscheidefeld E mit dem höchsten, unter den Nebenbedingungen von Plasmastrom und Temperatur erlaubten Wert $E_{max}$ gefahren:

Intervall I:

v > v$_1$    Regelgleichung lautet:

$$E(T) = h.V(T) / q.L.\kappa(d,T).z(d)$$

Intervall II:

v < v$_1$    Regelgleichung lautet bei dv/dt $\geq$ 0 ebenfalls

$$E(T) = h.V(T) / q.L.\kappa(d,T).z(d)$$

v < v$_1$    Regelgleichung lautet bei dv/dt < 0 dagegen

$$E(T) = E_{max}$$

Wobei E$_{max}$ die unter den Nebenbedingungen des erlaubten Plasmastroms größtmögliche Feldstärke darstellt.

Bei negativem zeitlichen Differential der Strömungsgeschwindigkeit v wird somit eine auf den Abbrand des Rußes optimierte Regelung der Spannungsimpulse unter Maximierung des Abscheidefeldes E vorgenommen, und bei positivem zeitlichen Differential der Strömungsgeschwindigkeit v eine auf die Abscheidung des Rußes optimierte Regelung der Spannungsimpulse, wobei hier versucht wird, das Abscheidefeld E zu minimieren, da sich ansonsten die Abscheidung des Rußes auf den Einlaufbereich der Kanäle 5 konzentriert, was einem nachträglichen Abbrand des Rußes und somit der Lebensdauer des Filters abträglich ist.

Für diese Regelung wird vorzugsweise ein eigener Prozessor des Russfilters vorgesehen sein. Die einfachste Umsetzung erhält man durch eine Messung des vorzugsweise am Filter selbst auftretenden Differenzdrucks (p$_1$ - p$_2$), der in guter Näherung direkt proportional zu der mittleren Strömungsgeschwindigkeit v in den Kanälen 5 des Keramikkörpers 7 ist, und dessen Zunahme oder Abnahme einen guten Rückschluss auf die Russemission des Motors erlaubt.

Dadurch ergibt sich die Umsetzung des erfindungsgemäßen Regelungsprinzips dadurch, dass man den am Filter, oder einem anderen entsprechenden Strömungswiderstand auftretenden Differenzdruck (p$_1$ - p$_2$) in mindestens zwei Intervalle teilt, wobei für den größeren Differenzdruck die normale Regelgleichung gilt, während für den geringeren Differenzdruck (p$_1$ - p$_2$) nur die normale Regelgleichung gilt, wenn die Ableitung des Differenzdrucks nach der Zeit positiv oder Null ist, also der Differenzdruck mit der Zeit zunimmt. Ist dagegen die Ableitung des Differenzdrucks nach der Zeit negativ, nimmt also der Differenzdruck mit der Zeit ab, so wird das Abscheidefeld E mit dem höchsten, unter den Nebenbedingungen des Plasmastroms und der Gastemperatur erlaubten Wert E$_{max}$ gefahren:

Intervall I:

(p$_1$ - p$_2$) > $\Delta$p$_1$    Regelgleichung lautet

$$E(T) = h.V(T) / q.L.\kappa(d,T).z(d)$$

Intervall II:

(p$_1$ - p$_2$) < $\Delta$p$_1$    Die Regelgleichung lautet bei:

$$d(p_1 - p_2) / dt \geq 0$$

ebenfalls

$$E(T) = h.V(T) / q.L.\kappa(d,T).z(d)$$

(p$_1$ - p$_2$) < $\Delta$p$_1$    Die Regelgleichung lautet bei

$$d(p_1 - p_2) / dt < 0$$

dagegen

$$E(T) = E_{max}$$

Falls der Filterprozessor selbst die zur optimalen Abscheidung des Rußes notwendige Spannungssteuerung berechnet und durchführt, kann der Motorprozessor auch entsprechende Informationen über Temperatur, Gasvolumenstrom oder Massenstrom, vorzugsweise auch AGR-Rate und Einspritzmenge über ein Signalsystem, vorzugsweise über CANBUS, zur Verfügung stellen. Dabei besteht ein weiterer Vorteil darin, dass der kleinere Filterprozessor schneller zu den notwendigen Spannungsänderungen kommt, und dadurch das durch Kapazitäten auf der Hochspannungsseite nur langsam regelbare Abscheidefeld rechtzeitig auf den neuen Russanfall einstellen kann.

Nachdem das Plasma im Filter ohnehin durch einen Mikroprozessor in Abhängigkeit von Temperatur, Restsauerstoff und vorzugsweise auch Feuchte und Russmenge geregelt wird, ist es von Vorteil, wenn dieser Prozessor auch Menge und Verteilung des abgelagerten Rußes berechnet, und danach sein Abscheidefeld E und insbesondere die zeitliche Aufteilung zwischen Ablagerungsfeldfeldstärke $E(T)$ und Regenerationsfeldstärke $E_{max}$ regelt. Obwohl die Information dazu durch filtereigene Sensoren, als auch durch filtereigene Analyse der Strom-Spannungskennlinien $i = i(U)$ und Differenzdrücke $(p_1 - p_2)$ ermittelt werden kann, können auch aus dem Prozessor der Motorsteuerung, vorzugsweise über einen CANBUS, entsprechende Daten wie Abgasmassenstrom, Einspritzmenge, AGR-Rate, Restsauerstoff und Russemission dem Filterprozessor zugeleitet werden.

Wall-flow-Filter mit bipolaren Spannungsimpulsen:

Bei dieser Art von Filtersystemen tritt der Abgasstrom durch Poren der Wände der lediglich einseitig offenen Kanäle 5 des Keramikkörpers 7 durch, wobei die Russpartikel zurück gehalten werden. In diesen so genannten "Wall-flow-Filter" erfolgt die Abscheidung der Russpartikel somit mechanisch. Diese Abscheidung kann dadurch noch wesentlich gesteigert werden, wenn die Russpartikel vor ihrer Abscheidung durch ein Entladungsgefäß geleitet werden, in dem eine unipolare Gasentladung die Partikel bis in die Nähe ihrer Sättigungsaufladung negativ auflädt.

Das Abscheidefeld E kann prinzipiell durch bipolare Spannungsimpulse erzeugt werden, oder durch unipolare Spannungsimpulse. Im ersten Fall erfolgt eine Abscheidung der Russpartikel an den beiden, in Feldrichtung gesehen gegenüberliegenden Wänden der Kanäle 5, und im zweiten Fall lediglich an einer Wand der Kanäle 5. Im Folgenden soll zunächst von bipolaren Spannungsimpulsen ausgegangen werden.

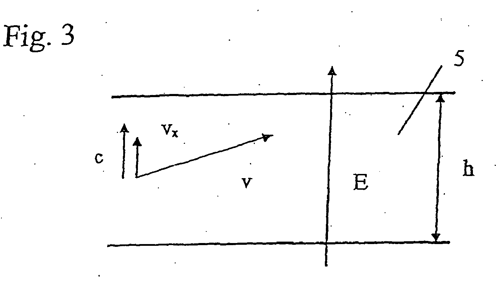

Da in diesem Fall die gesamte in den Kanal 5 eingeströmte Abgasmenge durch beide Seiten des Kanals 5 entweichen muss, kann als obere Abschätzung der Geschwindigkeitskomponente $v_x$ parallel oder antiparallel zur Feldrichtung einer Gasströmung mit der Strömungsgeschwindigkeit v angesetzt werden (siehe auch Fig. 3):

$$v_x = h/2t = h \cdot v/2L,$$

wobei h die Kanalhöhe und t die Durchlaufzeit des Abgasstromes durch einen Kanal der Länge L ist:

$$v = L/t$$

Ist somit die Strömungsgeschwindigkeit v bekannt, die im Zuge der Regelung des Filters ohnehin gemessen werden wird, um die angelegten Spannungsimpulse zu regeln, kann gemeinsam mit den ohnehin bekannten Geometrieparametern der Kanalhöhe h und der Kanallänge L die maximale Geschwindigkeitskomponente $v_x$ in Feldrichtung ermittelt werden. Die Driftgeschwindigkeit der Russpartikel mit Durchmesser d ergibt sich wiederum aus der Beweglichkeit $\kappa(d)$, der Ladungszahl $z(d)$ und der zeitabhängigen Feldstärke $E(t)$ des Wechselfeldes senkrecht auf die Kanalachse, wobei letztere durch die bipolaren Spannungsimpulse gegeben ist, sodass sich für die Driftgeschwindigkeit c für Russteilchen mit dem Durchmesser d ergibt:

$$c(d,t) = \kappa(d) \cdot z(d) \cdot E(t)$$

Die Beweglichkeit $\kappa(d)$ und die Ladungszahl $z(d)$ können für unterschiedliche Durchmesser d aus hinlänglich bekannten Tabellen, etwa der obigen Tabelle 1, abgelesen werden. Die durch die Ladungszahl $z(d)$ quantifizierte Aufladung der Russpartikel ist durch die vorherige Aufladung mittels der Entladungselektrode bedingt. Die Feldstärke $E(t)$ ist in bekannter Weise direkt durch die angelegten Spannungsimpulse gegeben. Somit können die im jeweiligen Anwendungsfall notwendige Feldstärke E, und somit die an die Elektroden des Keramikkörpers 7 anzulegende Spannung, abgeleitet werden.

Aus der so ermittelten Driftgeschwindigkeit kann auch leicht der während dieser Halbwelle zurückgelegte Driftweg s errechnet werden, nämlich als zeitliches Integral über die Zeitdauer der Halbwelle:

$$s(d) = \int c(d,t)dt$$

Aus der obigen Beziehung für die Driftgeschwindigkeit c

$$c(d,t) = \kappa(d).z(d).E(t)$$

ergibt sich die Bedingung für das Abscheiden der Russteilchen mit der obigen Beziehung

$$v_x = h.v/2L$$

zu

$$c(d,t) = h.v/2L$$

Mithilfe einer genaueren Untersuchung der strömungsdynamischen Vorgänge innerhalb der Kanäle 5 kann diese Abscheidebedingung noch verbessert werden. Und zwar zeigt sich in der Praxis, dass es bei einem herkömmlichen Wall-flow-Filter innerhalb von 150.000 km bis 200.000 km zu einem irreversiblen Verstopfen der Poren kommt. Dieses Verstopfen ist auf folgenden Mechanismus zurückzuführen: Durch das Einströmen in die Öffnungen der Poren wird das Abgas derart beschleunigt, dass es zu einer massiven Impaktierung der Russpartikel rund um die Porenöffnung kommt. Im Regenerationsprozess wird der Russ mit hoher lokaler Temperatur verbrannt, die Ölasche bleibt zurück, wird in den Porenrand eingebrannt, und setzt so die Einströmöffnung der Pore langsam zu. Dieser Mechanismus wird durch den steigenden Anteil von Biodiesel in den Dieselkraftstoffen beschleunigt, da der dadurch steigende Phosphatanteil zu einer sinkenden Kilometerleistung der Wall-flow-Filter führt. Durch die hohen Temperaturen bei der Regeneration des Filters wird nämlich Phosphor freigesetzt, der sich ebenso am Porenrand festsetzt, und so zu einer raschen und irreversiblen Verlegung der Poren führt. In der Zeit einer steigenden Beimengung von Biodiesel zu den Dieseltreibstoffen verringert sich daher die Lebensdauer der klassischen rein mechanisch arbeitenden Wall-flow-Filter dramatisch.

Um diese Nachteile zu vermeiden, können die bipolaren Spannungsimpulse so gewählt werden, dass die durch eine Halbwelle der Spannungsimpulse erzeugte Driftgeschwindigkeit c der aufgeladenen Russpartikel im Mittel größer oder gleich der Geschwindigkeitskomponente $v_x$ der maximalen Gasströmung in Feldrichtung des in den Kanälen 5 erzeugten, elektrischen Abscheidefeldes E ist. Überwiegt nämlich die Driftgeschwindigkeit c der elektrisch geladenen Russpartikel während der elektrischen Spannungsimpulse die Geschwindigkeitskomponente $v_x$ in Feldrichtung auf die Kanalwand zu, oder ist sie dieser zumindest gleich, so stellt sich eine überwiegend durch das elektrische Abscheidefeld E und nicht durch die lokale Strömungsgeschwindigkeit um die Porenöffnung gesteuerte Abscheidung ein. Eine solche Abscheidung findet allerdings über die gesamte Kanalwand verteilt statt, und nicht mehr nur in Porennähe. Die obige Abscheidebedingung modifiziert sich somit zu

$$c(d,t) > h.v/2L$$

Genauer für diese Ungleichung ist der oben erwähnte Driftweg $s(d)$ als Integral der Driftgeschwindigkeit $c(d,t)$ über die Zeit $t_1$ bis $t_2$ einer Halbperiode des Wechselfeldes:

$$s(d) = \int c(d,t)dt \qquad \text{Integral von } t_1 \text{ bis } t_2$$

oder

$$s(d) = \kappa(d).z(d) \int E(t)dt \qquad \text{Integral von } t_1 \text{ bis } t_2$$

Ist nun die Komponente in oder gegen die Feldrichtung des Weges $v_x . (t_2 - t_1)$ des auf die Kanalwand zuströmenden Gases während einer Halbwelle des Abscheidefeldes E kleiner als der Driftweg s(d) in dieser Halbwelle, also

$$\kappa(d).z(d) \int E(t)dt > v_x.(t_2 - t_1) \qquad \text{Integral von } t_1 \text{ bis } t_2$$

so wird das Russteilchen nicht in der Nähe einer offenen Pore, sondern irgendwo auf der Kanalwand abgeschieden. Aus der so berechneten, erforderlichen Größe des Abscheidefeldes E folgt unmittelbar die erforderliche Höhe der Spannungsimpulse, die an den parallel zu den Kanälen 5 verlaufenden Elektroden anzulegen ist, wobei hierzu die jeweilige, strukturelle Ausführung des Keramikkörpers 7 und seine Materialeigenschaften zu berücksichtigen sind. Da außerdem

$$v_x = h.v/2L$$

ist, ergibt sich somit die Regelung der Spannungsimpulse in Abhängigkeit von der Strömungsgeschwindigkeit v.
Für das Gleichheitszeichen in der obigen Ungleichung gilt, dass sich das Russteilchen in der Nähe, aber nicht unmittelbar an der Porenöffnung abscheidet, da dann die Driftgeschwindigkeit c(d) und die Geschwindigkeitskomponente $v_x$ ungefähr gleich groß sind.
Ein weiteres Kriterium für die notwendige Feldstärke E, um eine Abscheidung der Russpartikel am Porenrand zu verhindern, kann über eine genauere Betrachtung der Porendurchmesser gewonnen werden. Zu diesem Zweck dient der mittlere Durchmesser p der Einströmöffnung mit der offenen Fläche f als Ausgangspunkt. Eine einfache Näherung eines Porendurchmessers p erhält man insbesondere für Keramiken, deren oberflächliche Porenöffnungen sehr stark von der Kreisform abweichen. Mit

$$p^2\pi/4 = f \qquad \text{ergibt sich} \qquad p = 2(f/\pi)^{1/2}$$

Mit dieser Vorbemerkung ergibt sich eine vorteilhafte Wahl für den notwendigen Driftweg s innerhalb einer Halbwelle (von $t_1$ bis $t_2$), und somit für die Größe der Spannungsimpulse dadurch, dass der Driftweg s(d) innerhalb einer Halbwelle mindestens dem Zweifachen, vorzugsweise dem Dreifachen mittleren Durchmesser p der Porenöffnungen betragen soll, um eine Abscheidung am unmittelbaren Porenrand zu verhindern, also

$$s(d) > 2p$$

oder

$$\kappa(d).z(d) \int E(t)dt > 2p = 4(f/\pi)^{1/2} \qquad \text{Integral von } t_1 \text{ bis } t_2,$$

und vorzugsweise

$$\kappa(d).z(d) \int E(t)dt > 3p = 6(f/\pi)^{1/2} \qquad \text{Integral von } t_1 \text{ bis } t_2$$

Wird das hochfrequente Wechselfeld nicht laufend, sondern nur in Paketen gesendet, also etwa Paketdauer $T_1$ mit der anschließenden Pause $T_2$, so kann diese Abschätzung mit dem Reziprokwert des so genannten "Duty-cycle" $T_1/(T_1 + T_2)$ verschärft werden, also

$$\kappa(d).z(d)\int E(t)dt \; > \; 2p(T_1+ T_2)/T_1 \; = \; 4(f/\pi)^{1/2}(T_1+ T_2)/T_1$$
$$\text{Integral von } t_1 \text{ bis } t_2$$

und vorzugsweise zu

$$\kappa(d).z(d)\int E(t)dt \; > \; 3p(T_1+ T_2)/T_1 \; = \; 6(f/\pi)^{1/2}(T_1+ T_2)/T_1$$
$$\text{Integral von } t_1 \text{ bis } t_2$$

Wie bereits erwähnt wurde, wird das hochfrequente elektrische Abscheidefeld E nicht fortlaufend betrieben, sondern in kurzen Perioden von Schwingungen, so genannte hochfrequente bipolare Pulsfolgen, die aus mindestens einer oder einigen wenigen bipolaren Schwingungen bestehen, zerlegt, um das Bordnetz nicht zu überlasten.

Wählt man nun den Zeitabstand $\tau$ zwischen zwei bipolaren Impulsen oder Impulsfolgen zu groß, um den elektrischen Leistungsbedarf deutlich zu reduzieren, so können in der Pause dazwischen Russpartikel doch wieder in Porennähe gelangen und am Poreneingang impaktiert werden, bevor der nächste bipolare Impuls sie abscheidet. Daher muss der Weg $v_x$, den die vom Abgas getragenen Russpartikel zwischen zwei bipolaren Impulsen oder Impulsgruppen mit dem zeitlichen Abstand $\tau$ in Wandrichtung zurücklegen kleiner oder gleich sein als der Driftweg $s(d)$ als zeitliches Integral der Driftgeschwindigkeit $c(d,t)$ über eine Halbperiode des Wechselfeldes, also

$$v_x . \tau \; \leq \; s(d)$$

oder

$$v_x . \tau \; \leq \; \kappa(d).z(d)\int E(t)dt \qquad \text{Integral von } t_1 \text{ bis } t_2$$

Da Russteilchen je nach ihrem Durchmesser unterschiedliche Beweglichkeiten $\kappa(d)$ haben und unterschiedliche Sättigungsaufladungen $z(d)$ erlauben, ergeben sich im elektrischen Feld E auch unterschiedliche Driftgeschwindigkeiten $c(d)$. Tabelle 2 zeigt die bei zwei maximalen elektrischen Abscheidefeldstärken E (6 kV/cm und 8 kV/cm) erreichbaren Driftgeschwindigkeiten im Maximum der elektrischen Halbwelle:

Tabelle 2:

| Partikeldurchmesser | $\kappa(d)$ /cm$^2$/V.s/ (Beweglichkeit) | $z(d)$ (Ladezahl) | $\kappa(d).z(d)$ | $\kappa(d).z(d).E$ (E = 6 kV/cm) | $\kappa(d).z(d).E$ (E = 8 kV/cm) |
|---|---|---|---|---|---|
| 10 nm | $6{,}3 . 10^{-3}$ | 0,3 | $1{,}9. 10^{-3}$ | 11,4 cm/s | 15,2 cm/s |
| 20 nm | $1{,}3. 10^{-3}$ | 1 | $1{,}3. 10^{-3}$ | 7,8 cm/s | 10,4 cm/s |
| 100 nm | $1{,}0. 10^{-4}$ | 10 | $1{,}0. 10^{-3}$ | 6,0 cm/s | 8,0 cm/s |
| 1 $\mu$m | $5{,}4. 10^{-6}$ | 300 | $1{,}6. 10^{-3}$ | 9,6 cm/s | 12,8 cm/s |
| 10 $\mu$m | $5{,}4. 10^{-7}$ | 11 000 | $6{,}0. 10^{-3}$ | 36,0 cm/s | 48,0 cm/s |

Tabelle 3 zeigt mindestens notwendige Durchlaufzeiten des Abgasstromes in den Kanälen 5 eines Keramikkörpers 7 für zwei unterschiedliche Feldstärken im Maximum der elektrischen Spannungsimpulse, um die Ungleichung realisieren zu können. Die Daten wurden für einen Massendurchsatz von 500 kg/h bei 500°C und einem Gesamtquerschnitt des Wabenkörpers von 360 cm$^2$ bestimmt.

Tabelle 3:

| Partikeldurchmesser | $\kappa(d).z(d).E$ (6 kV/cm) | h = 0,8 mm t$\geq$ | h = 0,6 mm t$\geq$ | $\kappa(d).z(d).E$ (8 kV/cm) | h=0,8 mm t$\geq$ | h=0,6mm t$\geq$ |
|---|---|---|---|---|---|---|
| 10 nm | 111,4 cm/s | 14 ms | 11 ms | 15,2 cm/s | 11 ms | 8ms |

(fortgesetzt)

| Partikeldurchmesser | $\kappa(d).z(d).E$ (6 kV/cm) | h = 0,8 mm t≥ | h = 0,6 mm t≥ | $\kappa(d).z(d).E$ (8 kV/cm) | h=0,8 mm t≥ | h=0,6mm t≥ |
|---|---|---|---|---|---|---|
| 20 nm | 7,8 cm/s | 21 ms | 16 ms | 10,4 cm/s | 16 ms | 12 ms |
| 100 nm | 6,0 cm/s | 27 ms | 20 ms | 8,0 cm/s | 20 ms | 15 ms |
| 1 $\mu$m | 9,6 cm/s | 17 ms | 13 ms | 12,8 cm/s | 13 ms | 10 ms |
| 10 $\mu$m | 36,0 cm/s | 5 ms | 4 ms | 48,0 cm/s | 4 ms | 3 ms |

Mit einer Durchlaufzeit von t = 10 ms können bereits Abgasmengen von 500 kg/h bei 500°C bei vertretbaren Filterquerschnitten diese Bedingungen erfüllen. Dieser Abgasmassenstrom von 500 kg/h entspricht einem Volllastbetrieb eines aufgeladenen Dieselmotors der unteren Mittelklasse. Ein Abscheidefeld von 8 kV/cm kann also bei einer Kanalhöhe h von 0,6 mm auch bei Volllast alle Partikel entlang einer Abscheidewand ohne Beeinflussung durch Porenkanäle auffangen. Da Partikel mit Durchmessern um 100 nm nichts mehr zur Partikelzahl und noch nichts zur Partikelmasse beitragen, ist ein Filterbetrieb mit diesen Parametern durchaus akzeptabel, da bei diesen Temperaturen die Regeneration unter Plasma kontinuierlich und schnell abläuft. Die notwendigen Abscheidefelder E von bis zu 8 kV/cm liegen zwar deutlich über den derzeit üblichen Feldstärken von etwa 1.5-2 kV/cm, wie sie zum Zweck des Russabbrandes eingesetzt werden, diese Feldstärken sind aber insbesondere bei planaren Geometrien für den Keramikkörper 7 aufgrund verbesserter Keramiken durchaus zu verwirklichen.

Ist v die mittlere Strömungsgeschwindigkeit des Abgases in den Kanälen 5 des Keramikkörpers 7, so ergibt sich das erfindungsgemäße Regelprinzip bei einem Wall-flow-Filter, der mit bipolaren Spannungsimpulsen betrieben wird, nun dadurch, dass man die Strömungsgeschwindigkeit v wiederum in mindestens zwei Intervalle teilt, wo für die größere Strömungsgeschwindigkeit die normale Regelgleichung gilt, die Abscheidefeldstärke E bzw. die Spannungsimpulse also proportional zur Strömungsgeschwindigkeit v geregelt werden, während für die geringere Strömungsgeschwindigkeit v nur die normale Regelgleichung gilt, wenn die Ableitung der Strömungsgeschwindigkeit v nach der Zeit positiv oder Null ist, also die Strömungsgeschwindigkeit v mit der Zeit zunimmt oder gleich bleibt. Ist dagegen die Ableitung der Strömungsgeschwindigkeit v nach der Zeit negativ, nimmt also die Strömungsgeschwindigkeit v mit der Zeit ab, so wird das Abscheidefeld E mit dem höchsten, unter den Nebenbedingungen von Plasmastrom und Temperatur erlaubten Wert $E_{max}$ gefahren:

Intervall I:

$v > v_1$    Regelung nach mindestens einer der oben diskutierten Regelgleichungen, d.h.

$$\kappa(d).z(d)\int E(t)dt \; > \; v_x.(t_2 - t_1)$$

$$\kappa(d).z(d)\int E(t)dt \; > \; 2p$$

$$v_x.\tau \; \leq \; \kappa(d).z(d)\int E(t)dt$$

Intervall II:

$v < v_1$    Regelgleichung lautet bei dv/dt ≥ 0 ebenfalls

$$\kappa(d).z(d)\int E(t)dt \; > \; v_x.(t_2 - t_1)$$

$$\kappa(d).z(d)\int E(t)dt \; > \; 2p$$

$$v_x.\tau \; \leq \; \kappa(d).z(d)\int E(t)dt$$

$v < v_1$    Regelgleichung lautet bei $dv/dt < 0$ dagegen

$$E(T) = E_{max}$$

Wobei $E_{max}$ die unter den Nebenbedingungen des erlaubten Plasmastroms größtmögliche Feldstärke darstellt.

Bei negativem zeitlichen Differential der Strömungsgeschwindigkeit $v$ wird somit eine auf den Abbrand des Rußes optimierte Regelung der Spannungsimpulse unter Maximierung des Abscheidefeldes $E$ vorgenommen, und bei positivem oder verschwindendem zeitlichen Differential der Strömungsgeschwindigkeit $v$ eine auf die Abscheidung des Rußes optimierte Regelung der Spannungsimpulse, wobei hier versucht wird, das Abscheidefeld $E$ zu minimieren, da sich ansonsten die Abscheidung des Rußes auf den Einlaufbereich der Kanäle 5 konzentriert, was einem nachträglichen Abbrand des Rußes und somit der Lebensdauer des Filters abträglich ist.

Für diese Regelung wird wiederum ein eigener Prozessor des Russfilters vorgesehen sein. Die einfachste Umsetzung erhält man durch eine Messung des vorzugsweise am Filter selbst auftretenden Differenzdrucks ($p_1$ - $p_2$), der in guter Näherung direkt proportional zu der mittleren Strömungsgeschwindigkeit $v$ in den Kanälen 5 des Keramikkörpers 7 ist, und dessen Zunahme oder Abnahme einen guten Rückschluss auf die Russemission des Motors erlaubt. Um von dem durch unabgebrannten Russ erhöhten Filterdruck unabhängig zu sein, kann die Druckdifferenz auch an einem durch den Russ unveränderten Strömungswiderstand, vorzugsweise dem Entladungsgefäß, in dem die Entladungselektroden untergebracht sind, gemessen werden.

In diesem Fall ergibt sich eine Umsetzung des erfindungsgemäßen Regelprinzips dadurch, dass man den am Keramikkörper 7 oder einem anderen entsprechenden Strömungswiderstand auftretenden Differenzdruck ($p_1$ - $p_2$) in mindestens zwei Intervalle teilt, wo für den größeren Differenzdruck die normale Regelung gilt, während für den gerin-geren Differenzdruck ($p_1$ - $p_2$) die normale Regelung nur dann gilt, wenn die Ableitung des Differenzdrucks nach der Zeit positiv oder Null ist, also der Differenzdruck mit der Zeit zunimmt oder gleich bleibt. Ist dagegen die Ableitung des Differenzdrucks nach der Zeit negativ, nimmt also der Differenzdruck mit der Zeit ab, so wird das Feld $E$ mit dem größten, unter zumindest einer der Nebenbedingungen

$$v_x \cdot \tau \leq s(d) \quad \text{und/oder} \quad v_x \cdot (t_2 - t_1) < s(d)$$

möglichen Feld $E(T) = E_{max}$ gefahren.

**Intervall I:**

$$(p_1 - p_2) > \Delta p_1$$

Regelung nach mindestens einer der bisher diskutierten Regelgleichungen, d.h.

$$\kappa(d) \cdot z(d) \int E(t)\, dt > v_x \cdot (t_2 - t_1)$$

$$\kappa(d) \cdot z(d) \int E(t)\, dt > 2p$$

$$v_x \cdot \tau \leq \kappa(d) \cdot z(d) \int E(t)\, dt$$

**Intervall II:**

$$(p_1 - p_2) < \Delta p_1 \quad \text{mit} \quad d(p_1 - p_2)/dt \geq 0$$

Regelung nach mindestens einer der bisher diskutierten Regelgleichungen, d.h.

$$\kappa(d) \cdot z(d) \int E(t)\, dt > v_x \cdot (t_2 - t_1)$$

$$\kappa(d).z(d)\int E(t)dt \quad > \quad 2p$$

$$v_x.\tau \quad \leq \quad \kappa(d).z(d)\int E(t)dt$$

$$(p_1 - p_2) \quad < \quad \Delta p_1$$

Die Regelgleichung bei **$d(p_1 - p_2)/dt < 0$** lautet dagegen

$$E(T) = E_{max}$$

(unter den erlaubten Bedingungen)

Wall-flow-Filter mit unipolaren Spannungsimpulsen:

Eine weitere Möglichkeit, die Zeitstandsfestigkeit von Wall-flow-Filter zu erhöhen, besteht darin, das Abscheidefeld E innerhalb der Kanäle 5 des Keramikkörpers 7 mithilfe von unipolaren Spannungsimpulsen zu erzeugen. Dabei erfolgt wiederum die Abscheidung der Russpartikel in den Kanälen 5 des Keramikkörpers 7 nicht ausschließlich mechanisch, sondern das in den Kanälen 5 für den Russabbrand errichtete, elektrische Abscheidefeld E wird auch für die Abscheidung der Russpartikel verwendet, wobei hierzu eine weitere Elektrodenanordnung zur vorherigen Aufladung der Russpartikel vorgesehen ist. Werden nun unipolare Spannungsimpulse zur Abscheidung der Russpartikel im Wall-flow-Filter und anschließenden Regeneration des abgeschiedenen Rußes verwendet, so erfolgt die Abscheidung lediglich auf einer Wandseite der Kanäle 5, während die zweite, gegenüberliegende Wandseite immer rein bleibt. Daher kann auch kein Zusetzen von Poren, und damit kein Druckaufbau, stattfinden. Den durch die langfristig stattfindende Halbierung der Filterfläche tendenziell höheren Druck muss bei der Auslegung der Filtergröße und der Kanalabmessungen berücksichtig werden.

Mit dieser Vorgangsweise erreicht man, dass eine Wand der Kanäle vollkommen rein bleibt, und dem sie durchdringenden Gas einen gleich bleibend geringen Widerstand entgegensetzt. Die zweite Wand erhält zwar schneller einen höheren Russbelag und auch schneller einen irreversiblen Porenverschluss durch Ölasche und andere unverbrennbare Ablagerungen, aber der Druckverlust durch eine vollkommen reine Filterwand ist um so viel geringer, dass der anfangs geringere Druckverlust eines normalen Wall-flow-Filters nach wenigen 1000 km bereits eingeholt wird.

Die Strömungsgeschwindigkeit v der Gasströmung in den Kanälen sowie die Driftgeschwindigkeit c, die vom Durchmesser d der Russpartikel abhängig ist, können dabei wiederum leicht bestimmt werden. Die Strömungsgeschwindigkeit v wird im Zuge der Regelung des Filters ohnehin gemessen, um die angelegte Spannung zu regeln. Die Driftgeschwindigkeit c(d) der Russpartikel mit Durchmesser d ergibt sich wiederum aus der Beweglichkeit $\kappa(d)$, der Ladungszahl z(d) und der Feldstärke E senkrecht auf die Kanalachse, wobei letztere durch die unipolaren Spannungsimpulse gegeben ist, sodass sich für die Driftgeschwindigkeit c(d) für Russteilchen mit dem Durchmesser d ergibt:

$$c(d) = \kappa(d).z(d).E$$

Die Beweglichkeit $\kappa(d)$ und die Ladungszahl z(d) können für unterschiedliche Durchmesser d aus hinlänglich bekannten Tabellen, etwa der Tabelle 1, abgelesen werden. Die durch die Ladungszahl z(d) quantifizierte Aufladung der Russpartikel ist durch die vorherige Aufladung mittels der Entladungselektrode bedingt. Die Feldstärke E ist in bekannter Weise direkt durch die angelegten Spannungsimpulse gegeben. Anhand der erfindungsgemäßen Merkmale kann somit die im jeweiligen Anwendungsfall notwendige Feldstärke E, und somit die an die Elektroden anzulegende Spannung, abgeleitet werden. Die Einstellung der Driftgeschwindigkeit c, der Strömungsgeschwindigkeit v, der Kanalhöhe h und der Kanallänge L wird im Folgenden noch näher begründet werden:

Unter der Annahme, dass bei dieser Ausführungsvariante die gesamte, in den Kanal 5 eingeströmte Abgasmenge durch die zweite, unbeladene Seite entweichen muss, ergibt sich als obere Abschätzung der Geschwindigkeitskomponente $v_x$ der Strömungsgeschwindigkeit v des Abgases normal auf die Kanalachse zur freien Wand

$$v_x = h/t = h.v/L$$

wobei h die Kanalhöhe und t die Durchlaufzeit des Gases durch einen Kanal der Länge L ist:

$$v \quad = \quad L/t$$

Damit der Russ nicht durch die Gasströmung in die falsche Richtung mitgerissen wird, muss nun die Driftgeschwindigkeit c(d) der aufgeladenen Russteilchen mit dem Durchmesser d in Feldrichtung größer oder gleich sein, als die Geschwindigkeitskomponente $v_x$ gegen die Feldrichtung, also

$$c(d) \quad \geq \quad v_x$$

Mit der Beweglichkeit $\kappa(d)$, der Ladungszahl z(d) und der Feldstärke $E_x$ senkrecht auf die Kanalachse ergibt sich die Driftgeschwindigkeit c(d) für Russteilchen mit dem Durchmesser d

$$c(d) \quad = \quad \kappa(d).z(d).E$$

Damit ergibt sich die Bedingung für das Abscheiden der Russteilchen auf der richtigen Seite mit

$$v_x \quad = \quad h.v/L$$

zu

$$\kappa(d).z(d).E \quad \geq \quad h.v/L$$

Für das Gleichheitszeichen gilt, dass sich das Russteilchen in Bezug auf den Abstand zu den Kanalwänden praktisch nicht bewegt, da sich Driftgeschwindigkeit c(d) und die Geschwindigkeitskomponente $v_x$ gerade aufheben. Soll das Teilchen dagegen die richtige Wand erreichen, so muss erfindungsgemäß gelten

$$c(d) \quad \geq \quad 2v_x$$

oder

$$c(d)/v \geq 2.h/L$$

oder

$$\kappa(d).z(d).E \quad \geq \quad 2h.v/L$$

da das Teilchen im ungünstigsten Fall den doppelten Weg im Gas zurücklegen muss, wenn es ganz in der Nähe der nicht Russ tragenden Wand einströmt.

Da Russteilchen je nach ihrem Durchmesser d unterschiedliche Beweglichkeiten $\kappa(d)$ haben und unterschiedliche Sättigungsaufladungen z(d) erlauben, ergeben sich im elektrischen Feld E auch unterschiedliche Driftgeschwindigkeiten c(d). Tabelle 4 zeigt bei zwei für ein Gleichfeld erreichbaren mittleren elektrischen Abscheidefeldstärken E (3kV/cm und 4 kV/cm) entsprechenden Driftgeschwindigkeiten c:

Tabelle 4:

| Partikeldurchmesser | $\kappa(d)$ /cm²/V.s/ (Beweglichkeit) | z(d) (Ladezahl) | $\kappa(d).z(d)$ | $\kappa(d).z(d).E$ (E = 3 kV/cm) | $\kappa(d).z(d).E$ (E = 4 kV/cm) |
|---|---|---|---|---|---|
| 10 nm | $6,3. 10^{-3}$ | 0,3 | $1,9. 10^{-3}$ | 5,7 cm/s | 7,6 cm/s |

(fortgesetzt)

| Partikeldurchmesser | $\kappa(d)$ /cm$^2$/V.s/ (Beweglichkeit) | z(d) (Ladezahl) | $\kappa(d).z(d)$ | $\kappa(d).z(d).E$ (E = 3 kV/cm) | $\kappa(d).z(d).E$ (E = 4 kV/cm) |
|---|---|---|---|---|---|
| 20 nm | $1,3. 10^{-3}$ | 1 | $1,3. 10^{-3}$ | 3,9 cm/s | 5,2 cm/s |
| 100 nm | $1,0. 10^{-4}$ | 10 | $1,0. 10^{-3}$ | 3,0 cm/s | 4,0 cm/s |
| 1 μm | $5,4.10^{-6}$ | 300 | $1,6. 10^{-3}$ | 4,8 cm/s | 6,4 cm/s |
| 10 μm | $5,4. 10^{-7}$ | 11 000 | $6,0. 10^{-3}$ | 18,0 cm/s | 24,0 cm/s |

Tabelle 5 zeigt die für die vorliegenden Bedingungen notwendigen Kanalhöhen h bzw. mittleren Durchlaufzeiten t des Abgases durch die Kanäle 5 des unipolar betriebenen Wall-flow-Filters:

Tabelle 5:

| Partikel-durchmesser | $\kappa(d).z(d).E$ (3 kV/cm) | h = 0,8 mm t ≥ | h = 0,6 mm t ≥ | $\kappa(d).z(d).E$ (4 kV/cm) | h=0,8 mm t ≥ | h=0,6mm t ≥ |
|---|---|---|---|---|---|---|
| 10 nm | 5,7 cm/s | 28 ms | 21 ms | 7,6 cm/s | 21 ms | 16 ms |
| 20 nm | 3,9 cm/s | 41 ms | 31 ms | 5,2 cm/s | 31 ms | 23 ms |
| 100 nm | 3,0 cm/s | 53 ms | 40 ms | 4,0 cm/s | 40 ms | 30 ms |
| 1 μm | 4,8 cm/s | 33 ms | 25 ms | 6,4 cm/s | 25 ms | 19 ms |
| 10 μm | 18,0 cm/s | 9 ms | 7 ms | 24,0 cm/s | 7 ms | 5 ms |

Mit einer Durchlaufzeit von t = 20 ms können bereits Abgasmengen von 400 kg/h bei 550°C bei vertretbaren Filterquerschnitten diese Bedingungen erfüllen. Dieser Abgasmassenstrom von 400 kg/h entspricht einem Volllastbetrieb eines aufgeladenen Dieselmotors der unteren Mittelklasse. Ein Abscheidefeld E von 4 kV/cm kann also bei einer Kanalhöhe h von 0,6 mm auch bei Volllast alle Partikel bis auf die Größenklasse um 100nm entlang einer Abscheidewand auffangen. Da Partikel mit 100 nm Durchmesser nichts mehr zur Partikelzahl und noch nichts zur Partikelmasse beitragen, ist ein Filterbetrieb mit diesen Parametern durchaus akzeptabel, da bei diesen Temperaturen die Regeneration unter Plasma kontinuierlich und schnell abläuft.

Somit ist ersichtlich, dass Teilchen mit einem Durchmesser von etwa 100 nm die geringste Driftgeschwindigkeit c erreichen. Für diese sind in der Tabelle 6 zu einigen Kanalhöhen h notwendige Durchströmzeiten t angegeben, damit diese Teilchen die richtige Kanalwand erreichen können:

Tabelle 6:

| Kanalhöhe (mm) | 3 kV/cm | 4 kV7cm |
|---|---|---|
| 0,6 | 40 ms | 30 ms |
| 0,8 | 53 ms | 40 ms |
| 1,0 | 66 ms | 50 ms |

Die Schwierigkeit beim Betrieb eines Russfilters liegt dabei immer im Niedriglastbereich und wird insbesondere dann kritisch, wenn die Abscheidung des Filters auf eine hohe Motorleistung ausgelegt werden muss. Die höher motorisierten Mittelklassewagen unterscheiden sich zwischen Volllast und Stadtbetrieb im Gasvolumenstrom, wie erwähnt, um etwa den Faktor 10. Ist der Filter nun so ausgelegt, dass alle Partikel bei Volllast über die Filterlänge L (üblicherweise 20 cm bis 25 cm) abgeschieden werden, so findet diese Abscheidung im Stadtbetrieb auf den ersten 20 mm bis 25 mm statt. Damit, und besonders bei tiefen Motortemperaturen, kann die Regeneration des Filters lokal überfordert sein. Besonders kritisch wird die Situation, wenn die NOx-Emission gegen mehr Russemission abgetauscht wird.

Das Abscheidefeld kann daher proportional zu dem Gasvolumenstrom geregelt werden, damit sich die Russablagerung immer näherungsweise über die ganze Filterlänge L ausdehnt. Die entsprechende Regelgleichung kann aus der Beziehung

$$\kappa(d).z(d).E \quad \geq \quad 2h.v/L$$

abgeleitet werden, indem im Fall der Gültigkeit des Gleichheitszeichen die mittlere Gasgeschwindigkeit v in den Kanälen 5 ersetzt, wobei q der freie Gesamtquerschnitt aller Kanäle 5 darstellt

$$v = V/q$$

V ist dabei wiederum der Gasvolumenstrom. Dadurch ergibt sich die Regelgleichung für die Abscheidefeldstärke E als Funktion des Gasvolumenstroms V

$$E = 2hV/q.L.\kappa(d).z(d)$$

Wird noch die Temperaturabhängigkeit der Beweglichkeit K(d,T) und des Gasvolumenstroms V berücksichtigt, so ergibt sich für die Regelgleichung die Beziehung

$$E(d,T) = V(d,T).2h/q.L.\kappa(d,T).z(d) \quad ... \quad Gleichung (3)$$

Für d kann der Durchmesser mit dem kleinsten Produkt aus $\kappa(d).z(d)$ genommen werden, oder aber jener, deren Russpartikel gerade noch innerhalb der Filterlänge L abgeschieden werden sollen.

Aus der so berechneten, erforderlichen Größe des Abscheidefeldes E folgt unmittelbar die erforderliche Höhe der Spannungsimpulse, die an den parallel zu den Kanälen 5 verlaufenden Elektroden anzulegen ist, wobei hierzu die jeweilige, strukturelle Ausführung des Keramikkörpers 7 und seine Materialeigenschaften zu berücksichtigen sind. Aus der Gleichung (3) ergibt sich somit die Regelung der Spannungsimpulse in Abhängigkeit von der Strömungsgeschwindigkeit v, da V = q.v ist.

Wenn nun das Abscheidefeld E mit der Strömungsgeschwindigkeit v und der Temperaturkorrektur $q.v(T)/\kappa(d,T)$ geregelt wird, ergibt sich die weitere Schwierigkeit, dass bei geringer werdender Abscheidefeldstärke E auch die Plasmatemperatur und damit die Regenerationsgeschwindigkeit geringer wird, und letztendlich die Konversion des Rußes ganz erlischt. Bei tiefen Temperaturen und hohem Russanfall darf das Abscheidefeld E daher nicht unter eine vorgegebene Schranke geregelt werden. Besonders gravierend wird dieses Problem bei kurzen Volllastbeschleunigungen mit einem durch längeren Teillastbetrieb kalten Motor.

Dieses Problem kann dadurch gelöst werden, dass bei länger anhaltendem, hohen Russanfall ein entsprechend hohes Abscheidefeld E gesetzt wird, bei geringem Russanfall aber je nach Regenerationszustand des Filters zwischen hohem Feld und geringem Feld gewechselt wird, wobei vorzugsweise zu diesem Wechsel die Daten "hoher Russanfall" und "geringer Russanfall" sowie Gasmassenstrom aus dem Motorrechner über einen CANBUS an den Prozessor des Filters übertragen werden, oder der Wechsel wird direkt aus dem Motorrechner gesteuert, der dann Russmenge und Russverteilung im Filter selbst berechnet.

Ist v die mittlere Strömungsgeschwindigkeit des Abgases in den Kanälen 5 des Wabenkörpers 7, so ergibt sich ein vorteilhaftes Regelprinzip dadurch, dass man die Geschwindigkeit v in mindestens zwei Intervalle teilt, wo für die größere Strömungsgeschwindigkeit die normale Regelgleichung gilt, während für die geringere Strömungsgeschwindigkeit nur die normale Regelgleichung gilt, wenn die Ableitung der Geschwindigkeit nach der Zeit positiv oder annähernd Null ist, also die Geschwindigkeit mit der Zeit zunimmt oder konstant bleibt. Ist dagegen die Ableitung der Geschwindigkeit nach der Zeit negativ, nimmt also die Strömungsgeschwindigkeit mit der Zeit ab, so wird das Feld E mit dem höchsten, unter den Nebenbedingungen von Plasmastrom und Temperatur erlaubten Wert $E_{max}$ gefahren:

**Intervall I:**

**v > v$_1$** Die Regelgleichung lautet:

$$E(T) = 2h.V(T) / q.L.\kappa(d,T).z(d)$$

**Intervall II:**

**v < v₁**     Die Regelgleichung lautet bei **dv/dt ≥ 0** ebenfalls:

$$E(T) = 2h.V(T) / q.L.\kappa(d,T).z(d)$$

**v < v₁**     Die Regelgleichung lautet bei **dv/dt < 0** dagegen:

$$E(T) = E_{max}$$

wobei $E_{max}$ die unter den Nebenbedingungen des erlaubten Plasmastroms größtmögliche Feldstärke darstellt.

Natürlich kann der Prozessor des Russfilters diese Steuerung auch selbst durchführen. Die einfachste Umsetzung erhält man wiederum durch eine Messung des vorzugsweise am Filter selbst auftretenden Differenzdrucks ($p_1$ - $p_2$), der in guter Näherung direkt proportional zu der mittleren Strömungsgeschwindigkeit v in den Kanälen 5 des Wabenkörpers 7 ist, und dessen Zunahme oder Abnahme einen guten Rückschluss auf die Russemission des Motors erlaubt.

Dadurch ergibt sich eine Umsetzung des Regelprinzips dadurch, dass man den am Filter oder einem anderen entsprechenden Strömungswiderstand auftretenden Differenzdruck ($p_1$ - $p_2$) in mindestens zwei Intervalle teilt, wo für den größeren Differenzdruck die normale Regelgleichung gilt, während für den geringeren Differenzdruck ($p_1$ - $p_2$) nur die normale Regelgleichung gilt, wenn die Ableitung des Differenzdrucks nach der Zeit positiv oder annähernd Null ist, also der Differenzdruck mit der Zeit zunimmt oder konstant bleibt. Ist dagegen die Ableitung des Differenzdrucks nach der Zeit negativ, nimmt also der Differenzdruck mit der Zeit ab, so wird das Feld E mit dem höchsten, unter den Nebenbedingungen des Plasmastroms und der Gastemperatur erlaubten Wert $E_{max}$ gefahren:

**Intervall I:**

**($p_1$ - $p_2$) > $\Delta p_1$**     Die Regelgleichung lautet:

$$E(T) = 2h.V(T) / q.L.\kappa(d,T).z(d)$$

**Intervall II:**

**($p_1$ - $p_2$) < $\Delta p_1$**     Die Regelgleichung lautet bei

$$d(p_1 - p_2) /dt \geq 0$$

ebenfalls

$$E(T) = 2h.V(T) / q.L.\kappa(d,T).z(d)$$

**($p_1$ - $p_2$) < $\Delta p_1$**     Die Regelgleichung lautet bei

$$d(p_1 - p_2) /dt < 0$$

dagegen

$$E(T) = E_{max}$$

Eine sehr zweckmäßige und effiziente Umsetzung dieser Regelprinzipien kann erfindungsgemäß so durchgeführt werden, dass die "Regelgröße" ($p_1$ - $p_2$), durch die der "Stellwert" E(T) entsprechend gestellt werden soll, gemeinsam mit dem "Stellwert" E(T) als mindestens zweispaltige "Regeltabelle" in den Prozessor eingelesen und von ihm verarbeitet wird. Diese Vorgangsweise braucht am wenigsten Rechenkapazität und entwickelt die größte Regelgeschwindigkeit, um Spannung und Feld in Echtzeit an die Emissionen des Motors anzupassen. Sollen implizite Abhängigkeiten von weiteren Größen ebenfalls berücksichtigt werden, so kann es erfindungsgemäß besonders vorteilhaft sein, in die Tabelle mindestens eine zweite Regelgröße, also hier die Temperatur, einzulesen und dadurch die Möglichkeit zu schaffen, neben der Druckdifferenz eine weitere Regelebene für sehr unterschiedliche Temperaturen zu bekommen. Je nach Feinheit der Unterteilung für diese zweite Regelgröße erhalten wir weitere Spalten, in denen der Prozessor immer den entsprechenden Stellwert findet. Die Regeltabelle könnte dann folgendermaßen aussehen:

Tabelle 7

| Regelwert 1 | Regelwert 2 | Stellwert 1 für $T < T_1$ | Stellwert 2 $T_2 < T < T_1$ | Stellwert 3 für $T_2 < T$ |
|---|---|---|---|---|
| $(p_1 - p_2)_n$ | $T_n$ | $E_{n1}$ | $E_{n2}$ | $E_{n3}$ |
| $(p_1 - p_2)_{n+1}$ | $T_{n+1}$ | $E_{n1+1}$ | $E_{n2+1}$ | $E_{n3+1}$ |
| ... | ... | ... | ... | ... |

Ebenso geht der Prozessor bei dem Auffinden der Ableitung des Regelwertes nach der Zeit vor, indem er den Differentialquotient $d(p_1 - p_2)/dt$ durch die Differenz zweier hintereinander einlaufender Regelwerte ersetzt, also

$$d(p_1 - p_2)/dt = (p_1 - p_2)_n - (p_1 - p_2)_{n-1}$$

wobei die fehlende Normierung für den Regelvorgang unerheblich ist. Wir erhalten wieder

$$(p_1 - p_2)_n - (p_1 - p_2)_{n-1} \geq 0$$

ebenfalls

$$E(T) = 2h.V(T) / q.L.\kappa(d,T).z(d)$$

und mit

$$(p_1 - p_2)_n - (p_1 - p_2)_{n-1} < 0$$

dagegen

$$E(T) = E_{max}$$

Weitere Regelprinzipien:

Für alle vorgenannten Ausführungsbeispiele ergeben sich weitere Regelprinzipien, die im Folgenden erläutert werden sollen.

So empfehlen sich etwa weitere Maßnahmen zum Schutz der Filterelektronik und des Bordnetzes, sowie zum Schutz des Keramikkörpers 7. Der Keramikkörper 7 verhält sich nämlich bei Aufladung durch die Spannungsimpulse wie eine Kapazität, die somit eine Temperaturabhängigkeit zeigt, die vor allem aber durch den sinkenden ohmschen Widerstand der Keramik mit zunehmender Geschwindigkeit entladen wird. Der Ladestrom nimmt daher bei zunehmender Temperatur des Keramikkörpers zu, sodass auch die Leistungsaufnahme ohne Begrenzung unzulässige Werte erreichen würde. Andererseits droht bei zunehmender Temperatur des Keramikkörpers auch ein Spannungsdurchschlag, der den Keramikkörper schädigen könnte. Daher ist es vorteilhaft, wenn der Ladestrom während eines Spannungsimpulses gemessen wird, und die Spannungsimpulse so geregelt werden, dass das Produkt aus dem maximalen Wert der Spannungsimpulse und dem Ladestrom unterhalb eines vorgegebenen Wertes liegt.

Dabei ist es insbesondere vorteilhaft, wenn der vorgegebene Wert aus dem Produkt des maximalen Wertes der Spannungsimpulse und des maximalen Wertes für den Ladestrom gebildet wird, wobei der maximale Wert der Spannungsimpulse und der maximale Wert für den Ladestrom für unterschiedliche Intervalle der Strömungsgeschwindigkeit unterschiedlich gewählt werden, aber das Produkt jeweils konstant ist. Die Strömungsgeschwindigkeit ist nämlich ein Indikator für die Abgastemperatur und die Temperatur des Keramikkörpers, da höhere Strömungsgeschwindigkeiten bei höheren Motorleistungen auftreten. Durch diese Maßnahme werden die oben beschriebenen, negativen Folgen für die Filterelektronik und den Keramikkörper 7 wiederum unterbunden, wobei der maximale Wert für die Spannungsimpulse und der maximale Wert des Ladestromes für unterschiedliche Intervalle der Strömungsgeschwindigkeit unterschiedlich gewählt werden können. Das heißt, dass etwa bei Überschreiten einer bestimmten Strömungsgeschwindigkeit, und somit bei Überschreiten einer bestimmten Temperatur des Abgasstromes bzw. des Keramikkörpers 7, der maximal zulässige Wert für die Spannungsimpulse abgesenkt wird, und der maximale Wert für den Ladestrom erhöht wird, wobei jedoch ihr Produkt jeweils konstant bleibt. Das ermöglicht eine besonders effektive Regelung der Spannungsimpulse bei zunehmenden Temperaturen.

Eine weitere Regelgröße ist auch die Abgastemperatur T. Im Hochlastbereich beträgt die Temperatur bei motornaher Anordnung etwa 500°C bis 600°C, am Ende des Abgasstranges etwa 300°C bis 400°C. Bei den meisten der verwendeten Keramiken, wie etwa dem Kordierit, fällt die Durchschlagspannung nach einer kritischen Temperatur $T_k$, im Allgemeinen etwa bei 300°C bis 350°C, deutlich ab. Fährt man mit einem besonders hohen Abscheidefeld E, um auch im Hochlastbereich oder bei Volllast-Beschleunigung in die Nähe von 90% oder 100% Abscheidung zu kommen, so kann die Regelgleichung etwa für den Wall-flow-Filter mit unipolaren Spannungsimpulsen am Keramikkörper 7 um eine Temperaturfunktion f(T) erweitert werden:

$$E(V,t) \; = \; V(t).f(T).2h/q.L.\kappa(d,T).z(d)$$

Dabei ist die Temperaturfunktion vorzugsweise in zwei Intervalle geteilt, für die gilt

$$T \; < \; T_k \qquad f(T) = 1$$

$$T \; \geq \; T_k \qquad f(T) = 1 - \alpha.T$$

Hierbei wird die Konstante $\alpha$ an die Durchschlagsfestigkeit des Wabenkörpers angepasst. Natürlich kann die Funktion $f(T) = 1 - \alpha.T$ auch linear-quadratisch, exponentiell oder logarithmisch mit steigender Temperatur abnehmen.

Von ganz besonderer Wichtigkeit ist der Betrieb des Plasmas nach einem Kaltstart, wo zum Teil erhebliche Wassermengen in den Keramikkörper 7 gelangen. Hierzu kann ein eigener Programmteil im Mikroprozessor des Filters vorgesehen sein, der bei vorsichtigem Hochfahren der Spannung den dadurch verursachten Strom misst und auf einem Niveau hält, bei dem es zu keiner Schädigung des Keramikkörpers 7 kommen kann. So wird vorgeschlagen, dass nach dem Start des Dieselmotors der maximale Wert der Spannungsimpulse schrittweise auf die für den Dauerlastbetrieb vorgesehene Betriebsspannung erhöht wird, wobei bei jedem Schritt der Spannungserhöhung eine Messung des Ladestromes vorgenommen wird, und eine Erhöhung des maximalen Werts der Spannungsimpulse erst dann erfolgt, wenn der Ladestrom unterhalb einer vorgegebenen Größe verbleibt. Somit wird nach dem Startvorgang die Spannung am Keramikkörper 7 zunächst auf einen niedrigen Wert unterhalb der vorgesehenen Betriebsspannung hochgefahren, und der Ladestrom jeweils gemessen. Ist für diese erste, niedrige Spannung der Ladestrom oberhalb eines vorgegebenen Grenzwertes, so wird die Spannung für eine vorgegebene Zeit zunächst auf diesem niedrigen Wert gehalten. Danach wird die Spannung nach einer vorgegebenen Zeit etwa auf einen höheren Spannungswert erhöht, und wiederum der Ladestrom gemessen. Falls der Ladestrom wiederum oberhalb des vorgegebenen Wertes liegt, wird die Spannung wieder auf den vorangegangenen Wert zurückgefahren. Erst wenn der Ladestrom unterhalb des vorgegebenen Wertes verbleibt, wird die Spannung auf dem nächst höheren Spannungswert gehalten. Dieser Wert kann bereits die vorgesehen Betriebsspannung sein, oder es werden weitere Schritte der Spannungserhöhung vorgenommen.

Ist also für eine vorgegebene Spannung, die deutlich unter der vorgesehenen Betriebsspannung liegt, der Ladestrom $i_1$ über einem vorgegebenen Grenzwert ig, also

$$i_1 \; \geq \; i_g$$

so wird die Spannung für eine vorgegebene Zeit konstant gehalten, oder auch reduziert. Vorzugsweise wird die Spannung nach einer vorgegebenen Zeit ein zweites Mal auf einen höheren Spannungswert hochgefahren, die noch immer unter der Betriebsspannung liegt, und erneut der Strom $i_2$ gemessen. Ist

$$i_2 \geq i_g$$

wird der Vorgang erneut wiederholt. Ist hingegen

$$i_2 < i_g$$

wird die Spannung auf die normale Betriebsspannung hochgefahren, und die weitere Regelung den obigen Regelgleichungen überlassen.

Eine Analyse des unmittelbar nach dem Start des Dieselmotors freigesetzten Abgasstromes zeigt des Weiteren, dass er zunächst eine hohe Konzentration an Russpartikel enthält, die bei herkömmlichen Kraftfahrzeugen als dunkle "Startwolke" zumeist auch deutlich sichtbar ist, und eventuell auftretendes Kondenswasser erst danach im Abgasstrom auftritt. Daher wird vorgeschlagen, dass unmittelbar nach dem Start des Dieselmotors der maximale Wert der Spannungsimpulse zunächst der für den Dauerlastbetrieb vorgesehenen Betriebsspannung entspricht, und erst nach einer vorgegebenen Zeitdauer eine Absenkung des maximalen Werts der Spannungsimpulse auf einen Wert unterhalb der für den Dauerlastbetrieb vorgesehenen Betriebsspannung und eine anschließende, schrittweise Erhöhung erfolgt. Mithilfe dieser Maßnahmen wird erreicht, dass für die unmittelbar nach dem Start auftretende, hohe Konzentration an Ruß im Abgasstrom eine gute Abscheidung erreicht wird, und erst danach eine auf eventuell auftretendes Kondenswasser im Abgasstrang Rücksicht nehmende Regelung vorgenommen wird. Die vorgegebene Zeitdauer bis zur Absenkung der Spannungsimpulse hängt vom jeweiligen Motor, vor allem aber von seinem Abstand zum Motor ab, wird jedoch im Bereich weniger Sekunden liegen.

Besondere Schwierigkeiten erhält man dann, wenn bei sehr hohen Abgastemperaturen eine Zunahme der Plasmaleistung notwendig ist, da dann eine Regelung durch Erhöhung der Plasmaspannung wegen der reduzierten Durchschlagsfestigkeit zum Durchbruch des Plasmas durch die dünnen Wände des Keramikkörpers 7 führen kann.

Diese Schwierigkeiten lassen sich etwa dadurch beheben, indem die hochfrequenten Spannungsimpulse am Keramikkörper 7 einzeln, oder zu Paketen zusammengefasst mit einer Pause $\tau$ dazwischen zu einer Regelung benützt werden, indem die Länge der Pakete und/oder die Länge der Pausen $\tau$ ("duty cycle") zur Leistungserhöhung oder Verringerung benützt werden. Somit ersetzt eine Änderung der Impulsfolge eine Erhöhung oder Verringerung der Impulsspannung, die bei hohen Temperaturen den Keramikkörper 7 beschädigen könnte.

Schließlich können Maßnahmen zur Regelung der Spannung, die an die Entladungselektrode angelegt wird, vorgesehen sein. Hierbei wird zunächst vorgeschlagen, dass es sich dabei ebenfalls um unipolare Spannungsimpulse handelt, mit deren Hilfe die Eigenkapazität der Entladungselektrode und deren Zuleitung aufgeladen wird. Die Höhe dieser Aufladung bestimmt den Strom an der Entladungselektrode, wobei die Regelung durch die Spannungsimpulse zweckmäßiger Weise so stattfindet, dass der jeweilige Ladestrom, mit dem ein Spannungsimpuls die Entladungselektrode aufladet, mit einem Sollwert verglichen wird und dadurch den Entladungsstrom regelt. So wird erfindungsgemäß der Entladungsstrom in Abhängigkeit von der Russmenge, die aufgeladen werden muss, von der Temperatur des Abgases, oder von der Strömungsgeschwindigkeit, mit der der Abgasstrom die Filteranordnung durchströmt, geregelt.

Zur Regelung der Spannungsimpulse an der Entladungselektrode könnte einerseits wiederum die Strömungsgeschwindigkeit v, mit der der Abgasstrom die Kanäle 5 des Keramikkörpers 7 durchströmt, herangezogen werden, oder jene Strömungsgeschwindigkeit v, mit der der Abgasstrom die Entladungselektrode durchströmt, andererseits aber auch die Russmenge, die in der Entladungselektrode aufgeladen werden muss.

Da in allen oben beschriebenen Filtersystemen die Russpartikel vor ihrer elektrischen oder elektrisch unterstützten Abscheidung in einem Wabenkörper in einem Entladungsgefäß durch eine elektrische Entladung aufgeladen werden müssen, stellt eine erfindungsgemäße Regelung des Entladungsstroms proportional zur emittierten Russmenge eine vorteilhafte Ausführungsform der beschriebenen Anordnung dar, wobei sich die Regelung der Einspritzmenge oder einfach der Gaspedalstellung und in einer weiter verbesserten Ausführungsform auch der Abgasrückführung und des Restsauerstoffes im Abgas bedient. Durch diese Ausführungsform wird nicht nur der Leistungsbedarf aus dem Bordnetz minimiert, sondern auch die Lebensdauer der Entladungselektrode deutlich verbessert.

Auch hier stellt die effizienteste Umsetzung der Regelung mit dem Mikroprozessor das Einlesen einer mindestens zweispaltigen "Regeltabelle" dar, die den Regelwert, also eine mit dem Russmassenstrom (RMS) korrelierte Größe und den "Stellwert", also eine mit dem zu stellendem Wert des Entladungsstromes $i_e$ oder des Ladestromes $i_1$ oder der korrelierten Ladespannung $U_1$ darstellt. Erfindungsgemäß kann es besonders vorteilhaft sein, in die Tabelle eine zweite Regelgröße, also beispielsweise die Temperatur oder den Restsauerstoff einzulesen und dadurch die Möglichkeit zu schaffen, eine weitere Regelebene für sehr unterschiedliche Temperaturen oder Sauerstoffkonzentrationen im Abgas einzuführen. Zweckmäßiger Weise wird die Regeltabelle dann um mehrere Spalten des Stellwertes für verschiedene Werte des Regelwertes 2 angesetzt, also etwa

Tabelle 8

| Regelwert 1 | Regelwert 2 | StW 1 für $T_1$ | StW 2 für $T_2$ | StW 3 für $T_3$ | StW 4 für $T_4$ | StW 5 für $T_5$ |
|---|---|---|---|---|---|---|
| $RMS_n$ | $T_n$ | $i_{n1}$ | $i_{n2}$ | $i_{n3}$ | $i_{n4}$ | $i_{n5}$ |
| $RMS_{n+1}$ | $T_{n+1}$ | $i_{n1+1}$ | $i_{n2+1}$ | $i_{n3+1}$ | $i_{n4+1}$ | $i_{n5+1}$ |
| $RMS_{n+2}$ | $T_{n+2}$ | $i_{n1+2}$ | $i_{n2+2}$ | $i_{n3+2}$ | $i_{n4+2}$ | $i_{n5+2}$ |
| ... | ... | ... | ... | ... | ... | ... |

Insbesondere ist es auch von Vorteil, die Regelung des Entladungsstroms bei einem spontanen und stärkeren Tritt auf das Gaspedal überproportional hochzustellen, sozusagen mit einem "overboost", um die sich bei diesem Vorgang entwickelnde Russwolke abzufangen. Dies wird erfindungsgemäß am einfachsten so durchgeführt, dass man von dem jeweils angekommenen Regelwert "Gaspedalstellung" oder "Einspritzmenge" oder auch "Russmassenstrom" ($RMS_n$) den zuvor angekommenen ($RMS_{n-1}$) in Abzug bringt und für den Fall, dass dieser Wert eine festgelegte Schranke S übersteigt, also

$$(RMS_n) - (RMS_{n-1}) > S$$

eine überproportionale Regelung des Entladungsstromes $i_e$ zum Regelwert ($RMS_n$) durchführt. Erfindungsgemäß wird in einem solchen Fall die überproportionale Regelung des Stellwertes zum Regelwert innerhalb von 20 Sekunden, vorzugsweise innerhalb von 10 Sekunden auf die zum Regelwert proportionale Größe zurückgeführt.

Nun gibt es Fälle, in denen eine überproportionale Regelung des Entladungsstromes ($i_e$) zum Regelwert ($RMS_n$) trotzdem nicht zur vollen Aufladung der Russpartikel ("Sättigungsaufladung") führt und daher die geringer aufgeladenen Partikel im Abscheidefeld (E) langsamer und damit unvollständiger abgeschieden werden.

In solchen Fällen ist es von Vorteil, wenn zur überproportionalen Regelung des Entladungsstromes annähernd gleichzeitig eine überproportionale Regelung des Abscheidefeldes (E) stattfindet, wobei vorzugsweise das Abscheidefeld (E) auf den erlaubten Maximalwert gestellt wird.

Ebenso ist es vorteilhaft, nach einer überproportionalen Regelung des Entladungsstromes ($i_e$) zum Russmassenstrom (RMS) das Abscheidefeld (E) näherungsweise gleichzeitig mit dem Entladungsstrom ($i_e$) innerhalb von 20 Sekunden, vorzugsweise innerhalb von 10 Sekunden, auf die zur Strömungsgeschwindigkeit (v) proportionale Größe zu reduzieren.

Bleibt die Leistung des Motors über längere Zeit konstant, erhalten wir für den Wert

$$(RMS_n) - (RMS_{n-1}) = 0$$

und bleibt dieser Wert ohne Unterbrechung länger als beispielsweise 5 Minuten erhalten, so wird erfindungsgemäß die Regelung den Entladungsstrom $i_e$ um einen vorgegebenen Betrag, im Allgemeinen etwa 10% bis 30%, absenken und nach weiterer beispielsweise 5 Minuten wieder auf den ursprünglichen Wert anheben und diesen Vorgang bei gleichbleibender Motorleistung ad infinitum fortsetzen.

Zum Schutz der Entladungselektrode wird weiters vorgeschlagen, dass der Ladestrom i während eines Spannungsimpulses an der Entladungselektrode gemessen wird, und die Spannungsimpulse so geregelt werden, dass dieser Ladestrom i der Entladungselektrode unterhalb eines vorgegebenen Maximalwertes liegt. Insbesondere kann dabei vorgesehen sein, dass der vorgegebene Maximalwert für den Ladestrom i der Entladungselektrode bei Überschreiten einer vorgegebenen Strömungsgeschwindigkeit v, mit der der Abgasstrom die Filteranordnung durchströmt, abgesenkt wird. Die Strömungsgeschwindigkeit v des Abgasstromes etwa innerhalb der Entladungselektrode ist wiederum ein Indikator für die Abgastemperatur und die Temperatur der Entladungselektrode, da höhere Strömungsgeschwindigkeiten v bei höheren Motorleistungen auftreten. Diese Maßnahme dient deshalb dem Schutz der Entladungselektrode, da andernfalls die üblicherweise verwendeten Elektroden bei höheren Temperaturen instabil werden, und letztendlich beschädigt werden können.

Somit wird ein Verfahren für den Betrieb einer Filteranordnung zum Abscheiden von Russpartikel aus dem Abgasstrom eines Dieselmotors verwirklicht, die das Abscheide- und Abbrandverhalten des Filters optimieren, die Zeitstandsfestigkeit und die Betriebssicherheit der Filteranordnung erhöhen, und dabei einfach und stabil durchgeführt werden können.

**Patentansprüche**

1. Verfahren für den Betrieb einer Filteranordnung zum Abscheiden von Russpartikel aus dem Abgasstrom eines Dieselmotors, bei dem der Abgasstrom durch in Längsrichtung eines Keramikkörpers (7) verlaufende Kanäle (5) des Keramikkörpers (7) hindurchgeleitet wird, und an parallel zu den Kanälen (5) verlaufenden Elektroden (1,2) eine Spannung an den Keramikkörper (7) zur Erzeugung eines elektrischen Abscheidefeldes (E) in den Kanälen (5) des Keramikkörpers (7), das jeweils quer zur Achse der Kanäle (5) orientiert ist, angelegt wird, wobei vor dem Einleiten des Abgasstroms in die Kanäle (5) des Keramikkörpers (7) eine Aufladung der Russpartikel mithilfe einer Entladungselektrode erfolgt, und es sich bei jener Spannung, die an den parallel zu den Kanälen (5) verlaufenden Elektroden (1,2) angelegt wird, um Spannungsimpulse handelt, **dadurch gekennzeichnet, dass** die Spannungsimpulse in Abhängigkeit von der Strömungsgeschwindigkeit (v), mit der der Abgasstrom die Kanäle (5) des Keramikkörpers (7) durchströmt, geregelt werden.

2. Verfahren nach Anspruch 1, **dadurch gekennzeichnet, dass** zur Regelung der Spannungsimpulse des Abscheidefeldes (E) die Strömungsgeschwindigkeit (v) in zumindest zwei Intervalle unterteilt wird, wobei in zumindest einem Intervall der niedrigsten Strömungsgeschwindigkeiten (v) eine in Abhängigkeit vom zeitlichen Differential der Strömungsgeschwindigkeit (v) unterschiedliche Regelung vorgenommen wird, und im Intervall der höchsten Strömungsgeschwindigkeiten (v) die Regelung der Spannungsimpulse proportional zur Strömungsgeschwindigkeit (v) erfolgt.

3. Verfahren nach Anspruch 2, **dadurch gekennzeichnet, dass** bei negativem zeitlichen Differential der Strömungsgeschwindigkeit (v) eine auf den Abbrand des Rußes optimierte Regelung der Spannungsimpulse unter Maximierung des Abscheidefeldes (E) vorgenommen wird, und bei positivem oder verschwindendem zeitlichen Differential der Strömungsgeschwindigkeit (v) eine auf die Abscheidung und Verteilung des Rußes optimierte Regelung der Spannungsimpulse proportional zur Strömungsgeschwindigkeit (v) vorgenommen wird.

4. Verfahren nach Anspruch 2 oder 3, **dadurch gekennzeichnet, dass** eine mit dem zeitlichen Differential der Strömungsgeschwindigkeit (v) korrelierte Regelgröße durch Differenzbildung zweier aufeinander folgender Messwerte für eine mit dem Abgasmassenstrom korrelierte Größe, etwa der Strömungsgeschwindigkeit (v), bestimmt wird.

5. Verfahren nach einem der Ansprüche 2 bis 4, **dadurch gekennzeichnet, dass** bei Überschreiten eines vorgegebenen, positiven Wertes für das zeitliche Differential der Strömungsgeschwindigkeit (v), oder einer mit ihr korrelierten Regelgröße, eine, lediglich mit einem vorgegebenen Maximalwert begrenzte, überproportionale Regelung des Abscheidefeldes (E), und vorzugsweise auch eine überproportionale Regelung des Ladungsstromes (i), erfolgt.

6. Verfahren nach einem der Ansprüche 1 bis 5, **dadurch gekennzeichnet, dass** die Strömungsgeschwindigkeit (v), oder einer mit ihr korrelierten Regelgröße, gemeinsam mit dem dazugehörenden Abscheidefeld (E) als eine mindestens zweispaltige Regeltabelle in einen Prozessor eingelesen und verarbeitet wird, wobei gegebenenfalls weitere Spalten der Regeltabelle für weitere Regelgrößen, wie etwa der Temperatur des Abgases, sowie die dazugehörenden Stellwerte für das Abscheidefeld (E) vorgesehen sind.

7. Verfahren nach einem der Ansprüche 1 bis 6, **dadurch gekennzeichnet, dass** der Ladestrom (i) während eines Spannungsimpulses gemessen wird, und die Spannungsimpulse so geregelt werden, dass das Produkt aus dem maximalen Wert der Spannungsimpulse und dem Ladestrom (i) unterhalb eines vorgegebenen Wertes liegt.

8. Verfahren nach Anspruch 7, **dadurch gekennzeichnet, dass** der vorgegebene Wert aus dem Produkt aus dem maximalen Wert der Spannungsimpulse und einem maximalen Wert für den Ladestrom (i) gebildet wird, wobei der maximale Wert der Spannungsimpulse und der maximale Wert für den Ladestrom (i) für unterschiedliche Intervalle der Strömungsgeschwindigkeit (v) unterschiedlich gewählt werden, aber das Produkt jeweils konstant ist.

9. Verfahren nach Anspruch 7 oder 8, **dadurch gekennzeichnet, dass** nach dem Start des Dieselmotors der maximale Wert der Spannungsimpulse schrittweise auf die für den Dauerlastbetrieb vorgesehene Betriebsspannung erhöht wird, wobei bei jedem Schritt der Spannungserhöhung eine Messung des Ladestromes (i) vorgenommen wird, und eine Erhöhung des maximalen Werts der Spannungsimpulse erst dann erfolgt, wenn der Ladestrom (i) unterhalb einer vorgegebenen Größe verbleibt.

10. Verfahren nach Anspruch 9, **dadurch gekennzeichnet, dass** unmittelbar nach dem Start des Dieselmotors der maximale Wert der Spannungsimpulse zunächst der für den Dauerlastbetrieb vorgesehenen Betriebsspannung entspricht, und erst nach einer vorgegebenen Zeitdauer eine Absenkung des maximalen Werts der Spannungsimpulse auf einen Wert unterhalb der für den Dauerlastbetrieb vorgesehenen Betriebsspannung und eine anschließende, schrittweise Erhöhung nach Anspruch 9 erfolgt.

**11.** Verfahren nach einem der Ansprüche 1 bis 10, **dadurch gekennzeichnet, dass** es sich bei jener Spannung, die an die Entladungselektrode zur Aufladung der Russpartikel angelegt wird, ebenfalls um Spannungsimpulse handelt, wobei die Spannungsimpulse in Abhängigkeit von der Strömungsgeschwindigkeit (v), mit der der Abgasstrom die Entladungselektrode durchströmt, geregelt werden.

**12.** Verfahren nach Anspruch 11, **dadurch gekennzeichnet, dass** der Ladestrom während eines Spannungsimpulses an der Entladungselektrode gemessen wird, und die Spannungsimpulse so geregelt werden, dass dieser Ladestrom (i) der Entladungselektrode unterhalb eines vorgegebenen Maximalwertes liegt.

**13.** Verfahren nach Anspruch 12, **dadurch gekennzeichnet, dass** der vorgegebene Maximalwert für den Ladestrom (i) der Entladungselektrode bei Überschreiten einer vorgegebenen Strömungsgeschwindigkeit (v), mit der der Abgasstrom die Entladungselektrode durchströmt, abgesenkt wird.

**14.** Verfahren nach Anspruch 13, **dadurch gekennzeichnet, dass** der vorgegebene Maximalwert für den Ladestrom (i) der Entladungselektrode proportional zu einer mit dem Russmassenstrom (RMS) korrelierten Größe, wie etwa der Gaspedalstellung oder der Einspritzmenge an Dieselöl, geregelt wird.

**15.** Verfahren nach Anspruch 14, **dadurch gekennzeichnet, dass** die Regelung des Ladestroms (i) der Entladungselektrode zusätzlich zu der mit dem Russmassenstrom (RMS) korrelierten Größe, wie etwa der Gaspedalstellung oder der Einspritzmenge an Dieselöl, anhand der Konzentration des Restsauerstoffs im Abgas und/oder anhand der Abgasrückführung vorgenommen wird.

**Claims**

**1.** A method for operating a filter arrangement for separating soot particles from the exhaust gas stream of a diesel engine, in which the exhaust gas stream is conducted through ducts (5) of a ceramic body (7), which extend in the longitudinal direction of the ceramic body (7), and a voltage is applied to the ceramic body (7), to electrodes (1, 2) extending parallel to the ducts (5), to generate an electrical separation field (E) in the ducts (5) of the ceramic body (7), which is oriented in each case transversely to the axis of the ducts (5), before the introduction of the exhaust gas stream into the ducts (5) of the ceramic body (7), charging of the soot particles being performed with the aid of a discharge electrode, and the voltage which is applied to the electrodes (1, 2) extending parallel to the ducts (5) being in the form of voltage pulses, **characterized in that** the voltage pulses are regulated as a function of the flow velocity (v), at which the exhaust gas stream flows through the ducts (5) of the ceramic body (7).

**2.** The method according to Claim 1, **characterized in that**, to regulate the voltage pulses of the separation field (E), the flow velocity (v) is divided into at least two intervals, in at least one interval of the lowest flow velocities (v), a regulation which differs as a function of the time differential of the flow velocity (v) being performed, and, in the interval of the highest flow velocities (v), the regulation of the voltage pulses being performed proportionally to the flow velocity (v).

**3.** The method according to Claim 2, **characterized in that**, in the case of a negative time differential of the flow velocity (v), a regulation of the voltage pulses, which is optimized for the burn-off of the soot, is performed while maximizing the separation field (E), and in the case of a positive or negligible time differential of the flow velocity (v), a regulation of the voltage pulses proportional to the flow velocity (v), which is optimized for the separation and distribution of the soot, is performed.

**4.** The method according to Claim 2 or 3, **characterized in that** a regulating variable, which is correlated with the time differential of the flow velocity (v), is determined by differentiating two successive measured values for a variable correlated with the exhaust gas mass flow, for example, the flow velocity (v).

**5.** The method according to one of Claims 2 to 4, **characterized in that** if a predefined, positive value for the time differential of the flow velocity (v), or a regulating variable correlated therewith, is exceeded, a disproportionate regulation of the separation field (E), and preferably also a disproportionate regulation of the charge current (i), which is solely limited by a predefined maximum value, is performed.

**6.** The method according to one of Claims 1 to 5, **characterized in that** the flow velocity (v), or a regulating variable correlated therewith, is input and processed in a processor jointly with the associated separation field (E) as an at least two-column regulating table, optionally further columns of the regulating table being provided for further regulating variables, for example, the temperature of the exhaust gas, as well as the associated setting values for the separation field (E).

**7.** The method according to one of Claims 1 to 6, **characterized in that** the charging current (i) is measured during a voltage pulse, and the voltage pulses are regulated so that the product of the maximum value of the voltage pulse and the charge current (i) is less than a predefined value.

**8.** The method according to Claim 7, **characterized in that** the predefined value is calculated from the product of the maximum value of the voltage pulses and a maximum value for the charge current (i), the maximum value of the voltage pulses and the maximum value for the charge current (i) being selected to be different for different intervals of the flow velocity (v), but the respective product being constant.

**9.** The method according to Claim 7 or 8, **characterized in that**, after the start of the diesel engine, the maximum value of the voltage pulses is increased step-by-step to the operating voltage provided for continuous load operation, during each step of the voltage increase, a measurement of the charge current (i) being performed, and an increase of the maximum value of the voltage pulses only being performed if the charge current (i) remains less than a predefined variable.

**10.** The method according to Claim 9, **characterized in that**, immediately after the start of the diesel engine, the maximum value of the voltage pulses initially corresponds to the operating voltage provided for continuous load operation, and a reduction of the maximum value of the voltage pulses to a value below the operating voltage provided for continuous load operation and a subsequent step-by-step increase according to Claim 9 only being performed after a predefined time duration.

**11.** The method according to one of Claims 1 to 10, **characterized in that** the voltage which is applied to the discharge electrode to charge the soot particles is also in the form of voltage pulses, the voltage pulses being regulated as a function of the flow velocity (v), at which the exhaust gas stream flows through the discharge electrode.

**12.** The method according to Claim 11, **characterized in that** the charge current is measured during a voltage pulse at the discharge electrode, and the voltage pulses are regulated so that this charge current (i) of the discharge electrode is less than a predefined maximum value.

**13.** The method according to Claim 12, **characterized in that** the predefined maximum value for the charge current (i) of the discharge electrode is decreased if the flow velocity, at which the exhaust gas stream flows through the discharge electrode, exceeds a predefined flow velocity (v).

**14.** The method according to Claim 13, **characterized in that** the predefined maximum value for the charge current (i) of the discharge electrode is regulated proportionally to a variable correlated with the soot mass flow (SMF), for example, the gas pedal position or the injection quantity of diesel oil.

**15.** The method according to Claim 14, **characterized in that** the regulation of the charge current (i) of the discharge electrode is performed, in addition to the variable correlated with the soot mass flow (SMF), for example, the gas pedal position or the injection quantity of diesel oil, on the basis of the concentration of the residual oxygen in the exhaust gas and/or on the basis of the exhaust gas recirculation.

**Revendications**

**1.** Procédé pour faire fonctionner une disposition de filtre pour séparer des particules de suie du flux de gaz d'échappement d'un moteur diesel, dans lequel le flux de gaz d'échappement est guidé à travers des canaux (5) d'un corps en céramique (7) passant dans le sens longitudinal du corps en céramique (7) et une tension est appliquée au corps en céramique (7) sur des électrodes (1, 2) parallèles aux canaux (5) pour produire dans les canaux (5) du corps en céramique (7) un champ de séparation électrique (E) qui est orienté perpendiculairement à l'axe des canaux (5), dans lequel, avant l'introduction du flux de gaz d'échappement dans les canaux (5) du corps en céramique (7), les particules de suie sont chargées à l'aide d'une électrode de décharge et chaque tension appliquée aux électrodes (1, 2) parallèles aux canaux (5) est constituée d'impulsions de tension, **caractérisé en ce que** les impulsions de tension sont régulées en fonction de la vitesse d'écoulement (v) à laquelle le flux de gaz d'échappement parcourt les canaux (5) du corps en céramique (7).

2. Procédé selon la revendication 1, **caractérisé en ce que** pour la régulation des impulsions de tension du champ de séparation (E), la vitesse d'écoulement (v) est divisée en au moins deux intervalles, une régulation différente étant réalisée en fonction du différentiel de temps de la vitesse d'écoulement (v) dans au moins un intervalle de plus petite vitesse d'écoulement (v) et la régulation des impulsions de tension étant proportionnelle à la vitesse d'écoulement (v) dans l'intervalle de plus grande vitesse d'écoulement (v).

3. Procédé selon la revendication 2, **caractérisé en ce que** lorsque le différentiel de temps de la vitesse d'écoulement (v) est négatif, une régulation des impulsions de tension optimisée en fonction de la combustion de la suie est réalisée en maximisant le champ de séparation (E), et lorsque le différentiel de temps de la vitesse d'écoulement (v) est positif ou effacé, une régulation des impulsions de tension optimisée en fonction de la séparation et de la répartition de la suie en proportion de la vitesse d'écoulement (v) est réalisée.

4. Procédé selon la revendication 2 ou 3, **caractérisé en ce qu'**une grandeur de régulation corrélée avec le différentiel de temps de la vitesse d'écoulement (v) est déterminée en calculant la différence de deux valeurs de mesure successives pour une grandeur corrélée au débit de masse de gaz d'échappement, par exemple à la vitesse d'écoulement (v).

5. Procédé selon l'une des revendications 2 à 4, **caractérisé en ce que** lorsqu'une valeur positive prédéterminée du différentiel de temps de la vitesse d'écoulement (v) ou une grandeur de régulation corrélée à celle-ci est dépassée, il se produit une régulation sur-proportionnelle du champ de séparation (E) limitée seulement par la valeur maximale prédéterminée, et de préférence aussi une régulation sur-proportionnelle du courant de charge (i).

6. Procédé selon l'une des revendications 1 à 5, **caractérisé en ce que** la vitesse d'écoulement (v) ou une grandeur de régulation corrélée à celle-ci est lue et traitée dans un processeur en même temps que le champ de séparation (E) correspondant sous la forme d'un tableau de régulation à au moins deux colonnes, d'autres colonnes étant éventuellement prévues dans le tableau de régulation pour d'autres grandeurs de régulation, par exemple pour la température des gaz d'échappement ainsi que pour les valeurs de réglage correspondantes pour le champ de séparation (E).

7. Procédé selon l'une des revendications 1 à 6, **caractérisé en ce que** le courant de charge (i) est mesuré pendant une impulsion de tension et les impulsions de tension sont régulées de telle manière que le produit de la valeur maximale des impulsions de tension et du courant de charge (i) soit inférieur à une valeur prédéterminée.

8. Procédé selon la revendication 7, **caractérisé en ce que** la valeur prédéterminée est formée à partir du produit de la valeur maximale des impulsions de tension et d'une valeur maximale du courant de charge (i), la valeur maximale des impulsions de tension et la valeur maximale du courant de charge (i) étant choisies différentes pour différents intervalles de la vitesse d'écoulement (v) tandis que le produit est chaque fois constant.

9. Procédé selon la revendication 7 ou 8, **caractérisé en ce qu'**après le démarrage du moteur diesel, la valeur maximale des impulsions de tension est graduellement augmentée jusqu'à la tension de service prévue pour le fonctionnement en charge continu, une mesure du courant de charge (i) étant réalisée à chaque étape de l'augmentation de la tension et la valeur maximale des impulsions de tension n'étant augmentée que lorsque le courant de charge (i) reste inférieur à la grandeur prédéterminée.

10. Procédé selon la revendication 9, **caractérisé en ce qu'**immédiatement après le démarrage du moteur diesel, la valeur maximale des impulsions de tension correspond tout d'abord à la tension de service prévue pour le fonctionnement en charge continu, et la valeur maximale des impulsions de tension n'est réduite qu'après un intervalle de temps prédéterminé à une valeur inférieure à la tension de service prévue pour le fonctionnement en charge continu et après une augmentation graduelle selon la revendication 9.

11. Procédé selon l'une des revendications 1 à 10, **caractérisé en ce que** chaque tension appliquée à l'électrode de décharge pour charger les particules de suie est également formée d'impulsions de tension, lesquelles impulsions de tension sont régulées en fonction de la vitesse d'écoulement (v) à laquelle le flux de gaz d'échappement parcourt l'électrode de décharge.

**12.** Procédé selon la revendication 11, **caractérisé en ce que** le courant de charge est mesuré pendant une impulsions de tension sur l'électrode de décharge et les impulsions de tension sont régulées de telle manière que ce courant de charge (i) de l'électrode de décharge se situe en dessous d'une valeur maximale prédéterminée.

**13.** Procédé selon la revendication 12, **caractérisé en ce que** la valeur maximale prédéterminée du courant de charge (i) de l'électrode de décharge est réduite lorsqu'une vitesse d'écoulement (v) prédéterminée à laquelle le flux de gaz d'échappement parcourt l'intervalle de décharge est dépassée.

**14.** Procédé selon la revendication 13, **caractérisé en ce que** la valeur maximale prédéterminée pour le courant de charge (i) de l'électrode de décharge est proportionnelle à une grandeur corrélée au débit de masse de suie (RMS), par exemple à la position de la pédale d'accélérateur ou au débit d'injection du carburant diesel.

**15.** Procédé selon la revendication 14, **caractérisé en ce que** la régulation du courant de charge (i) de l'électrode de décharge est réalisée, en plus de la grandeur corrélée au débit de masse de suie (RMS), par exemple à la position de la pédale d'accélérateur ou au débit d'injection du carburant diesel, à l'aide de la concentration d'oxygène résiduel dans les gaz d'échappement et/ou à l'aide du recyclage des gaz d'échappement.

Fig. 1

Fig. 2

Fig. 3

**EP 2 150 685 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2004141890 A